(19) Europäisches Patentamt
European Patent Office
Office européen des brevets

(11) **EP 3 780 069 B1**

(12) **EUROPEAN PATENT SPECIFICATION**

(45) Date of publication and mention
of the grant of the patent:
**11.12.2024   Bulletin 2024/50**

(21) Application number: **19776881.5**

(22) Date of filing: **22.03.2019**

(51) International Patent Classification (IPC):
**H01L 21/02** *(2006.01)*        **C09K 3/14** *(2006.01)*

(52) Cooperative Patent Classification (CPC):
**C09K 3/1463; H01L 21/02024**

(86) International application number:
**PCT/JP2019/011978**

(87) International publication number:
**WO 2019/188747 (03.10.2019 Gazette 2019/40)**

(54) **GALLIUM COMPOUND SEMICONDUCTOR SUBSTRATE POLISHING COMPOSITION**

POLIERZUSAMMENSETZUNG FÜR HALBLEITERSUBSTRAT AUS GALLIUMVERBINDUNG

COMPOSITION DE POLISSAGE DE SUBSTRAT SEMI-CONDUCTEUR COMPOSÉ DE GALLIUM

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:  **28.03.2018   JP 2018061192**
**28.03.2018   JP 2018061193**

(43) Date of publication of application:
**17.02.2021   Bulletin 2021/07**

(73) Proprietor: **Fujimi Incorporated**
**Kiyosu-shi, Aichi 452-8502 (JP)**

(72) Inventors:
• **ODA, Hiroyuki**
**Kiyosu-shi, Aichi 452-8502 (JP)**
• **KON, Hiroki**
**Kiyosu-shi, Aichi 452-8502 (JP)**
• **NOGUCHI, Naoto**
**Kiyosu-shi, Aichi 452-8502 (JP)**
• **TAKAMI, Shinichiro**
**Kiyosu-shi, Aichi 452-8502 (JP)**

(74) Representative: **Grünecker Patent- und Rechtsanwälte PartG mbB Leopoldstraße 4 80802 München (DE)**

(56) References cited:
WO-A1-2017/150118        JP-A- 2007 067 153
JP-A- 2007 109 777        JP-A- 2015 153 852
JP-A- 2015 189 829        JP-A- H02 262 956
US-A1- 2008 194 182       US-A1- 2008 299 350
US-A1- 2010 184 292       US-A1- 2014 024 216

**Description**

**Technical Field**

The present invention relates to a polishing composition, and specifically, to a polishing composition used for polishing a gallium compound-based semiconductor substrate. In addition, the present invention relates to a method for polishing a gallium compound-based semiconductor substrate and a polishing composition set used in the method. Priority is claimed on Japanese Patent Application Publication No. 2018-61192 filed on March 28, 2018 and Japanese Patent Application Publication No. 2018-61193 filed on March 28, 2018.

**Background Art**

As compound semiconductor materials used for a power device, a light emitting diode (LED), and the like, gallium compound-based semiconductor substrates such as a gallium nitride substrate and a gallium oxide substrate have grown in importance. When a power device or the like is produced using a gallium compound-based semiconductor, since it is generally necessary to obtain a smooth surface without causing processing damage, the surface of the gallium compound-based semiconductor substrate is polished. Examples of technical literature related to polishing of a nitride semiconductor substrate of such as gallium nitride include Patent Literature 1 to 5.

Citation List

Patent Literature

    Patent Literature 1: Japanese Patent Application Publication No. 2015-153852
    Patent Literature 2: Japanese Patent Application Publication No. 2013-201176
    Patent Literature 3: Japanese Patent No. 5116305
    Patent Literature 4: US 2014/024216 A1
    Patent Literature 5: JP 2007 109777 A

**Summary of Invention**

Technical Problem

Compound semiconductors are generally chemically very stable and have low reactivity, and some of them have very high hardness such as gallium nitride, and are not generally easily processed by polishing. Therefore, generally, compound semiconductor substrates are polished (lapped) by supplying a diamond abrasive to a polishing platen and then finished by being subjected to polishing that is performed by supplying a slurry containing an abrasive between a polishing pad and an object to be polished in order to remove scratches occurring due to the lapping and the like and chemical etching using a solution containing no abrasive. Patent Literature 1 and 2 relate to technologies for polishing a nitride semiconductor crystal using a slurry containing an abrasive, and improving the polishing removal rate mainly by the examination of the particle diameter of the abrasive. However, there is a trend that the surface quality required for compound semiconductor substrates is gradually increasing, and the technologies described in Patent Literature 1 and 2 cannot fully satisfy this demand. In addition, Patent Literature 3 proposes that a gallium nitride semiconductor substrate that has been polished using a first polishing composition (primary polishing) is additionally polished using a second polishing composition (secondary polishing). However, while there is a trend that the surface quality required for compound semiconductor substrates is gradually increasing, it is also required to maintain a practical polishing removal rate in consideration of productivity. The technology described in Patent Literature 3 cannot fully satisfy this demand.

The present invention has been made in view of the above circumstances, and an object of the present invention is to provide a polishing composition which is used for polishing a gallium nitride or other gallium compound-based semiconductor substrate and can achieve both high polishing removal rate and a higher-quality surface after polishing. Another related object is to provide a method of polishing a gallium compound-based semiconductor substrate using the polishing composition. Still another object is to provide a polishing method for a gallium nitride or other gallium compound-based semiconductor substrate through which a high-quality surface can be efficiently realized. Another related object is to provide a polishing composition set suitable for realizing such a polishing method. Solution to Problem

In this specification, there is provided a polishing composition configured to be used for polishing a gallium compound-based semiconductor substrate. The polishing composition contains a silica abrasive, a compound $C_{pho}$ having a phosphoric acid group or a phosphonic acid group (hereinafter simply referred to as a "compound $C_{pho}$") and water. Here, the polishing composition contains no oxidant. Since the polishing composition contains the silica abrasive, it is possible to more efficiently remove the surface of the gallium compound-based semiconductor substrate which is an object to be polished, compared to etching using a solution containing no abrasive. In addition, since the compound $C_{pho}$ is contained and no oxidant is contained, it is possible to reduce roughening of the surface of the object to be polished due to polishing and improve the surface quality after polishing.

The polishing composition disclosed here is implemented using, as the compound $C_{pho}$, for at least one of the following: (A) a chelate compound having a phosphonic acid group, (B) a compound selected from the group consisting of phosphoric acid mono $C_{1-4}$ alkyl esters, phosphoric acid di $C_{1-4}$ alkyl esters and phosphorous acid mono $C_{1-4}$ alkyl esters, (C) at least one of phosphoric acid and phosphorous acid, and (D) a compound selected from the group consisting of inorganic salts of phosphoric acid and inorganic salts of phosphorous acid.

In the polishing composition disclosed here, the pH is less than 2. Since a polishing composition having a pH of less than 2 is used, a surface having high surface quality can be efficiently realized.

The polishing composition disclosed here may further contain an acid. When a combination of the compound $C_{pho}$ and an acid is used, favorable surface quality can be efficiently realized. A content m 1 [mol/kg] of the compound $C_{pho}$ and a content m2 [mol/kg] of the acid in the polishing composition are preferably set to satisfy the following formula: $m1/(m1 + m2) \geq 0.1$.

The polishing composition disclosed here is configured to be used as a polishing composition for polishing a gallium nitride substrate or a gallium oxide substrate.

In this specification, there is provided a method for polishing a gallium compound-based semiconductor substrate. The polishing method includes supplying any one of the polishing compositions disclosed here to a gallium compound-based semiconductor substrate and polishing the substrate. According to such a polishing method, it is possible to effectively improve the surface quality of the gallium compound-based semiconductor substrate.

In this specification, there is provided a method of polishing a gallium compound-based semiconductor substrate (hereinafter referred to as an "object to be polished"). The polishing method includes a first polishing step in which polishing is performed using a slurry S1 containing an abrasive A1 and water; and a second polishing step in which polishing is performed using a slurry S2 containing an abrasive A2 and water, in this order. Here, the abrasive A2 contains a silica abrasive. In addition, the slurry S2 further contains a compound $C_{pho}$ having a phosphoric acid group or a phosphonic acid group. The slurry S1 does not contain the compound $C_{pho}$ or a concentration [% by weight] of the compound $C_{pho}$ in the slurry S1 is lower than a concentration [% by weight] of the compound $C_{pho}$ in the slurry S2. According to such a polishing method, since the object to be polished which has been polished using the slurry S1 is additionally polished using the slurry S2 containing the compound $C_{pho}$, it is possible to achieve both minimizing an increase in the polishing time and a high-quality surface after polishing.

In some embodiments, the pH of the slurry S1 may be less than 2.0. When the slurry S1 having such a low pH is used, high polishing removal rate is easily obtained in the first polishing step. After the first polishing step is performed using the slurry S1 having such a low pH, when the second polishing step is performed using the slurry S2 containing the compound $C_{pho}$, a high-quality surface can be efficiently realized.

In some embodiments, the slurry S1 containing a strong acid can be preferably used. When a strong acid is used, it is possible to efficiently control the pH of the slurry S1.

In some embodiments, the slurry S1 may contain an oxidant. When the second polishing step is performed after the first polishing step is performed using the slurry S1 having such a composition, a high-quality surface can be efficiently realized. Regarding the oxidant, at least one selected from the group consisting of a permanganate, metavanadate, and persulfate can be preferably used.

The abrasive A1 may contain a silica abrasive. When the first polishing step is performed using the slurry S1 containing a silica abrasive, the surface quality of the object to be polished can be efficiently improved in the second polishing step performed thereafter.

The pH of the slurry S2 is less than 2. Since the slurry S2 having a low pH is used, high polishing removal rate is easily obtained in the second polishing step. In addition, since the slurry S2 contains the compound $C_{pho}$, even at a low pH, it is possible to reduce roughening of the surface of the object to be polished and obtain a high-quality surface after polishing.

The concentration of the compound $C_{pho}$ in the slurry S2 is 0.05% by weight or more and 25% by weight or less. Thereby, it is possible to suitably achieve both high polishing removal rate and a high-quality surface after polishing in the second polishing step.

The polishing pad used for polishing in the second polishing step is preferably a polishing pad having a soft polyurethane foam surface. When the second polishing step is performed using such a polishing pad, a high-quality surface is easily obtained after polishing.

In this specification, there is provided a polishing composition set that can be obtained using any of the polishing methods disclosed here. The polishing composition set includes a composition Q1 which is the slurry S1 or its concentrate; and a composition Q2 which is the slurry S2 or its concentrate. Here, the composition Q1 and the composition Q2 are stored separately from each other. The polishing composition set having such a configuration can be suitably used for realization.

The matters disclosed in this specification include a polishing composition which is used in the second polishing step in any of the polishing methods disclosed here, which is the slurry S2. The polishing composition can be preferably used as, for example, the composition Q2 constituting a polishing composition set disclosed here. The pH of the slurry S2 is than 2.0 preferably less than 1.5.

**Description of Embodiments**

Preferred embodiments of the present invention will be described below. Incidentally, matters that are other than those particularly mentioned herein but are necessary for implementation of the present invention can be recognized by those skilled in the art as design matters based on the prior art in the relevant field. The present invention can be implemented based on content disclosed herein and common general technical knowledge in the field.

<Object to be polished>

The art disclosed here is applied to polishing of a gallium compound-based semiconductor substrate as an object to be polished. The concept of the gallium compound-based semiconductor in this specification includes gallium nitride (GaN) and gallium oxide ($Ga_2O_3$), and also a semiconductor having a composition in which some of Ga in such compounds is replaced with other Group 13 elements (B, Al, In) in the periodic table, for example, AlGaN, GaInN, and AlGaInN. The art disclosed here can be preferably applied for polishing of a substrate having a surface made of such a gallium compound-based semiconductor material. The surface, that is, the surface to be polished, may be a surface made of any one type of gallium compound-based semiconductor material, for example, a single crystal surface of the material, or may be a surface made of a mixture of two or more types of gallium compound-based semiconductor materials, for example, a mixed crystal surface of these materials. The gallium compound-based semiconductor substrate may be a free-standing type gallium compound-based semiconductor wafer or may have a gallium compound-based semiconductor crystal on an appropriate underlayer. Examples of such an underlayer include a sapphire substrate, a silicon substrate, and a SiC substrate. The gallium compound-based semiconductor may be doped or non-doped in order to impart conductivity or the like.

Examples of preferable targets to which the art disclosed here is applied include a gallium nitride substrate and a gallium oxide substrate. The gallium oxide substrate typically has a surface made of $\beta$-$Ga_2O_3$ crystals and preferably has a surface made of $\beta$-$Ga_2O_3$ single crystals. The gallium nitride substrate typically has a surface made of GaN crystals and preferably has a surface made of GaN single crystals. A main surface of a GaN crystal, that is, a reference plane of a polishing target surface, is not particularly limited. Examples of polishing target surfaces include polar surfaces such as a C plane; non-polar surfaces such as an A surface and an M surface; semi-polar surfaces; and the like.

<Polishing composition>

(Abrasive)

The polishing composition disclosed here contains an abrasive. According to polishing using a polishing composition containing an abrasive, compared to chemical etching using a solution containing no solid particles such as an abrasive, for example, it is possible to more efficiently remove scratches occurring on an object to be polished in a previous step such as lapping. In addition, the scratches can be efficiently removed while reducing roughening of the surface due to polishing by the polishing composition disclosed here when the composition includes a compound $C_{pho}$ to be described below.

The polishing composition disclosed here contains at least a silica abrasive as the abrasive. It is easy to obtain high surface quality by a polishing composition containing a silica abrasive. The silica abrasive used can be appropriately selected from among various known silica particles. Examples of such known silica particles include colloidal silica and dry silica. Among these, colloidal silica is preferably used. A high polishing removal rate and favorable surface accuracy can be suitably achieved by a silica abrasive containing colloidal silica. Examples of colloidal silica referred to here include silica produced using an alkali silicate-containing solution containing an alkali metal such as Na and K, and $SiO_2$ (for example, a sodium silicate-containing solution) as a raw material, and silica (alkoxide silica) produced by a hydrolytic condensation reaction of an alkoxysilane such as tetraethoxysilane and tetramethoxysilane. In addition, examples of dry silica include silica (fumed silica) obtained by burning silane compounds such as silicon tetrachloride and trichlorosilane typically in a hydrogen flame and silica produced by a reaction between metallic silicon and oxygen.

An abrasive whose surface is modified may be used. Specifically, the surface of the abrasive is modified by changing a potential of the surface of the abrasive by attaching or binding a substance having a potential different from that of the surface of the abrasive to the surface of the abrasive. The substance used for changing a potential of the surface of the abrasive is not limited, but when the abrasive is, for example, silicon oxide, a surfactant, an inorganic acid, an organic acid, and a metal oxide such as aluminum oxide can be used as the substance.

In order to improve surface quality after polishing, the art disclosed here can be suitably realized in an embodiment in which the proportion of the silica abrasive is more than 70% by weight with respect to a total weight of abrasives contained in the polishing composition. The proportion of the silica abrasive is more preferably 90% by weight or more, still more preferably 95% by weight or more, and particularly preferably 99% by weight or more. Among these, a polishing composition in which 100% by weight of abrasives contained in the polishing composition are silica abrasives is preferable.

The average secondary particle diameter of the abrasive contained in the polishing composition is suitably 5 nm or more, preferably 10 nm or more, and more preferably 20 nm or more. When the average secondary particle diameter of the abrasive increases, the polishing removal rate of the object to be polished by the polishing composition tends to improve. In some embodiments, the average secondary particle diameter of the abrasive may be 35 nm or more or 50 nm or more. In addition, in order to obtain a higher-quality surface, the average secondary particle diameter of the abrasive is suitably 300 nm or less, preferably 200 nm or less, more preferably 150 nm or less, and may be 100 nm or less or 80 nm or less.

Here, in the art disclosed here, the average secondary particle diameter of the abrasive refers to a volume average particle diameter (volume average diameter D50) based on a dynamic light scattering method. The average secondary particle diameter of the abrasive can be measured using a commercially available dynamic light scattering method particle size analyzer, and for example, it can be measured using a model "UPA-UT151" (commercially available from Nikkiso Co., Ltd.) or its equivalent.

The abrasive contained in the polishing composition may be of one type or two or more types having different materials, particle shapes or particle sizes. In consideration of dispersion stability of the abrasive and quality stability of the polishing composition, in the polishing composition according to some embodiments, 90% by weight or more, more preferably 95% by weight or more, and still more preferably 99% by weight or more of abrasives contained in the composition may be one type of silica abrasive. For example, the polishing composition disclosed here can be preferably realized in an embodiment in which only one type of silica abrasive is contained as an abrasive.

The concentration of the abrasive in the polishing composition is not particularly limited. The concentration of the abrasive may be, for example, 5% by weight or more, 12% by weight or more, 17% by weight or more, or 22% by weight or more. When the concentration of the abrasive increases, the polishing removal rate by the polishing composition tends to improve. In addition, in order to achieve a high level of balance between a polishing removal rate and surface quality after polishing, the concentration of the abrasive is generally suitably about 50% by weight or less, and preferably 40% by weight or less. The polishing composition disclosed here can also be preferably realized in an embodiment in which the concentration of the abrasive is 35% by weight or less or 30% by weight or less.

(Water)

The polishing composition disclosed here contains water as an essential component. Ion-exchange water (deionized water), pure water, ultrapure water, distilled water, or the like can be preferably used as water. The polishing composition disclosed here may further contain, as necessary, an organic solvent (a lower alcohol, a lower ketone, etc.) that can be uniformly mixed with water. Generally, the amount of water is preferably 90 vol% or more and more preferably 95 vol% or more (typically, 99 to 100 vol%) with respect to the solvent contained in the polishing composition.

(Compound $C_{pho}$)

The polishing composition disclosed here contains a compound $C_{pho}$ having a phosphoric acid group or a phosphonic acid group as an essential component. Since the polishing composition containing an abrasive includes the compound $C_{pho}$, roughening of the surface of the object to be polished due to polishing is reduced, and surface quality after polishing can be improved. Thereby, a surface having a low surface roughness Ra and with reduced occurrence of pits can be effectively realized. The compounds $C_{pho}$ can be used solely or two or more thereof can be used in combination.

The compound $C_{pho}$ may be an inorganic compound or an organic compound. Examples of the compound $C_{pho}$, which is an inorganic compound, include phosphoric acid ($H_2PO_4$), phosphorous acid ($H_3PO_3$), and inorganic salts thereof. The inorganic salt may be, for example, an alkali metal salt such as a sodium salt, a potassium salt, and a lithium salt. Specific examples of inorganic salts of phosphoric acid include alkali metal phosphates and alkali metal hydrogen phosphates such as tripotassium phosphate, dipotassium hydrogen phosphate, potassium dihydrogen phosphate, trisodium phosphate, disodium hydrogen phosphate, and sodium dihydrogen phosphate. Here, the compound $C_{pho}$ contained

in the polishing composition can contain a tautomer thereof. For example, a polishing composition containing phosphorous acid as the compound $C_{pho}$ can contain phosphorous acid and also phosphonic acid which is a tautomer thereof.

Examples of the compound $C_{pho}$, which is an organic compound, include phosphate esters and phosphites. Monoesters and diesters are preferably used, and a mixture of monoesters and diesters may be used as the phosphate esters. The molar ratio of monoesters and diesters in the mixture may be, for example, 20:80 to 80:20 or 40:60 to 60:40. In addition, monoesters can be preferably used as the phosphites.

As an organic group that forms an ester bond with phosphoric acid or phosphorous acid, a hydrocarbon group of about $C_{1-20}$ is preferable, a $C_{1-12}$ hydrocarbon group is more preferable, a $C_{1-8}$ hydrocarbon group is still more preferable, and a $C_{1-4}$ hydrocarbon group is particularly preferable. Here, in this specification, $C_{X-Y}$ means that "the number of carbon atoms is X or more and Y or less". The hydrocarbon group may be aliphatic or aromatic. The aliphatic hydrocarbon group may be saturated or unsaturated, linear or cyclic, and linear or branched.

In the polishing composition disclosed here, at least one selected from the group consisting of phosphoric acid mono $C_{1-4}$ alkyl esters and phosphoric acid di $C_{1-4}$ alkyl esters can be used as the compound $C_{pho}$. For example, a mixture of a monoethyl phosphate and a diethyl phosphate can be used as the compound $C_{pho}$.

The compound $C_{pho}$, which is an organic compound, may be a chelate compound having a phosphonic acid group. Examples of such a compound $C_{pho}$ include a chelate compound having two or more phosphonic acid groups in one molecule such as 1-hydroxyethylidene-1,1-diphosphonic acid, aminotris(methylenephosphonic acid), ethylenediamine tetra(methylenephosphonic acid), diethylenetriamine penta(methylenephosphonic acid), ethane-1,1-diphosphonic acid, ethane-1,1,2-triphosphonic acid, ethane-1-hydroxy-1,1-diphosphonic acid, ethane-1-hydroxy-1,1,2-triphosphonic acid, and ethane-1,2-dicarboxy-1,2-diphosphonic acid; a chelate compound having one phosphonic acid group in one molecule such as 2-aminoethylphosphonic acid, methanehydroxyphosphonic acid, 2-phosphonobutane-1,2-dicarboxylic acid, 1-phosphonobutane-2,3,4-tricarboxylic acid, and $\alpha$-methylphosphonosuccinic acid; and the like. In order to easily suitably achieve both minimizing a reduction in the polishing removal rate and improving surface quality after polishing, the number of phosphonic acid groups of the compound $C_{pho}$ is advantageously 1 or more and 4 or less and preferably 1 or more and 3 or less, and particularly preferably 1 or 2 per molecule. For the same reason, the molecular weight of the compound $C_{pho}$ is advantageously 800 or less, preferably 600 or less, more preferably 400 or less, and still more preferably 300 or less or 250 or less.

Other examples of the compound $C_{pho}$, which is an organic compound, include salts of phosphoric acid or phosphorous acid and an organic cation.

The polishing composition disclosed here is implemented using, as the compound $C_{pho}$, at least one of: (A) a chelate compound having a phosphonic acid group, (B) a compound selected from the group consisting of phosphoric acid mono $C_{1-4}$ alkyl esters, phosphoric acid di $C_{1-4}$ alkyl esters and phosphorous acid mono $C_{1-4}$ alkyl esters, (C) at least one of phosphoric acid and phosphorous acid, and (D) a compound selected from the group consisting of inorganic salts of phosphoric acid and inorganic salts of phosphorous acid. The compound $C_{pho}$ may include two or more compounds selected from any one of the above (A) to (D) or may include two or more compounds selected from two or more of the above (A) to (D). Alternatively, the compound $C_{pho}$ may include only one type of compound selected from any one of the above (A) to (D).

The concentration [% by weight] of the compound $C_{pho}$ in the polishing composition is 0.05% by weight or more, preferably 0.08% by weight or more, more preferably 0.15% by weight or more, and may be 0.2% by weight or more or 0.4% by weight or more. When the concentration of the compound $C_{pho}$ increases, surface quality after polishing generally tends to improve. In some embodiments, the concentration of the compound $C_{pho}$ may be 0.5% by weight or more, more than 0.5% by weight, 0.8% by weight or more, 2.5% by weight or more, or 4.0% by weight or more. In addition, in order to achieve both improvement of surface quality and favorable polishing removal rate, the concentration of the compound $C_{pho}$ is 25% by weight or less, preferably 20% by weight or less, or 15% by weight or less. In some embodiments, the concentration of the compound $C_{pho}$ may be, for example, 10% by weight or less, 6% by weight or less, 3% by weight or less, 1.5% by weight or less, or 1.0% by weight or less.

The above concentration of the compound $C_{pho}$ can be used as a concentration of the compound $C_{pho}$ in the polishing composition when it is supplied to an object to be polished for use in polishing, that is, a concentration of the compound $C_{pho}$ when the composition is used (point-of-use; POU). Hereinafter, the polishing composition when it is supplied to the object to be polished will be referred to as a "working slurry". In addition, in the polishing composition disclosed here, a concentration of the compound $C_{pho}$ at the abrasive content (abrasive concentration) of 25% by weight is within the range of the above concentration of the compound $C_{pho}$. Here, the concentration of the compound $C_{pho}$ at the abrasive concentration of 25% by weight refers to a concentration of the compound $C_{pho}$ converted so that the abrasive concentration becomes 25% by weight. For example, when the concentration of the abrasive is X% by weight and the concentration of the compound $C_{pho}$ is Y% by weight, the concentration of the compound $C_{pho}$ at the abrasive concentration of 25% by weight can be calculated by the following formula: $Y \times (25/X)$.

(Oxidant)

In the polishing composition used in the final polishing step performed on a surface of a material to be polished, the concentration of the oxidant is preferably a predetermined value or less.

In the conventional technology for polishing a gallium compound-based semiconductor substrate using a polishing composition containing an abrasive, in order to promote polishing and the like, an oxidant such as hydrogen peroxide ($H_2O_2$) is generally contained. However, the inventors have found that when an oxidant is contained in the polishing composition containing silica abrasive and the compound $C_{pho}$, an effect of improving surface quality by the compound $C_{pho}$ is impaired. Thereby, the polishing composition does not contain an oxidant. The polishing composition disclosed here can be preferably realized in an embodiment in which at least none of hydrogen peroxide, sodium persulfate, potassium persulfate, ammonium persulfate, and sodium dichloroisocyanurate is contained. Here, when it is described that the polishing composition contains no oxidant, this means that an oxidant is at least not intentionally added and a case in which a very small amount of an oxidant resulting from raw materials, a production method, or the like is inevitably included is acceptable. A very small amount indicates that a molar concentration of the oxidant in the polishing composition is 0.0005 mol/L or less (preferably 0.0001 mol/L or less, more preferably 0.00001 mol/L or less, and particularly preferably 0.000001 mol/L or less). The concentration of the oxidant is preferably zero or a detection limit or less.

(pH)

The pH of the polishing composition disclosed here is less than 2.0, preferably less than 1.5, or less than 1.3. It is possible to effectively reduce roughening of a surface of an object to be polished even at a low pH by the polishing composition disclosed here when the composition includes the compound $C_{pho}$. Accordingly, it is possible to suitably achieve both favorable polishing removal rate and high surface quality. The lower limit of the pH of the polishing composition is not particularly limited, and in consideration of minimizing corrosion of a facility and environmental hygiene, it is generally suitably 0.5 or more or may be 0.7 or more.

Here, in this specification, the pH can be determined by using a pH meter, by performing 3-point calibration using a standard buffer solution (phthalate pH buffer solution pH: 4.01 (25°C), a neutral phosphate pH buffer solution pH: 6.86 (25°C), and a carbonate pH buffer solution pH: 10.01 (25°C)), and then adding a glass electrode to a measurement target composition, and measuring a value after stabilization for 2 minutes or longer. For example, a glass electrode hydrogen ion concentration indicator (model number F-23, commercially available from Horiba Ltd.) or its equivalent may be used as the pH meter.

(Acid)

The polishing composition disclosed here may contain, as necessary, one or more acids as optional components used for adjusting a pH and the like, in addition to the abrasive, water, and the compound $C_{pho}$ which are essential components. Acids corresponding to the compound $C_{pho}$, that is, phosphoric acid, phosphorous acid, and phosphonic acid, are not included in examples of the acids. Specific examples of acids include inorganic acids such as sulfuric acid, nitric acid, hydrochloric acid, phosphinic acid, and boric acid; organic acids such as acetic acid, itaconic acid, succinic acid, tartaric acid, citric acid, maleic acid, glycolic acid, malonic acid, methanesulfonic acid, formic acid, malic acid, gluconic acid, alanine, glycine, lactic acid, trifluoroacetic acid, and trifluoromethanesulfonic acid; and the like. The acid may be used in the form of a salt of the acid. The salt of the acid may be, for example, an alkali metal salt such as a sodium salt and a potassium salt, or an ammonium salt. When the compound $C_{pho}$ and an acid are used in combination, even if the amount of the compound $C_{pho}$ used is reduced compared to when the acid is not used, favorable surface quality can be efficiently realized. This can be advantageous in consideration of economic efficiency and environmental burden reduction.

In the polishing composition according to some embodiments, the composition includes a combination of the compound $C_{pho}$ and a strong acid. When a small amount of a strong acid is used, the pH of the polishing composition can be effectively adjusted. A strong acid having a pKa of less than 1 is preferable, a strong acid having a pKa of less than 0.5 is more preferable, and a strong acid having a pKa of less than 0 is still more preferable. In addition, an oxo acid is preferable as the strong acid. Preferred examples of a strong acid that can be used in the polishing composition disclosed here include hydrochloric acid, sulfuric acid, and nitric acid.

The concentration of the acid is not particularly limited and can be appropriately set so that the effects of the present invention are not significantly impaired. The concentration of the acid may be, for example, 0.05% by weight or more, 0.1% by weight or more, or 0.3% by weight or more. In order for the compound $C_{pho}$ to effectively act, in some embodiments, the concentration of the acid may be, for example, less than 5% by weight, less than 3% by weight, less than 1.5% by weight, less than 1.1% by weight, or less than 1.0% by weight. The concentration of the above acid can be preferably applied as a concentration of a strong acid (particularly an oxo acid) among the acids. In addition, in the polishing composition disclosed here, preferably, a concentration of the acid at the abrasive concentration of 25% by weight should be within the range of the above concentration of the acid. The concentration of the acid at the abrasive concentration of 25% by weight can be calculated in the same manner as the concentration of the compound $C_{pho}$ at the abrasive concentration of 25% by weight.

In some embodiments, a total of the concentration w1 [% by weight] of the compound $C_{pho}$ and the concentration w2 [% by weight] of an acid (preferably a strong acid) in the polishing composition, that is, w1+w2, may be, for example, 0.1% by weight or more, and in order to achieve both polishing efficiency and surface quality after polishing to a higher level, it may be generally preferably 0.3% by weight or more, 0.5% by weight or more, or 0.7% by weight or more. In addition, w1+w2 may be, for example, 30% by weight or less, and in order to achieve a balance between polishing removal rate and surface quality after polishing at a higher level, it may be generally preferably 25% by weight or less, 20% by weight or less, 15% by weight or less, or 10% by weight or less. The polishing composition disclosed here can be preferably realized in an embodiment in which w1+w2 is, for example, 5% by weight or less, 3% by weight or less, 2% by weight or less, 1.5% by weight or less or 1.4% by weight or less.

When the polishing composition disclosed here contains a combination of the compound $C_{pho}$ and an acid (preferably a strong acid), regarding the contents thereof, the relationship between the content m1 [mol/kg] of the compound $C_{pho}$ and the content m2 [mol/kg] of the acid can be set to satisfy the following formula:

$$m1/(m1 + m2) \geq 0.1;$$

That is, on a molar basis, it is preferable that 10% or more of a total amount of the compound $C_{pho}$ and the acid contained in 1 kg of the polishing composition be the compound $C_{pho}$. In setting in this manner, both polishing removal rate and favorable surface quality after polishing tend to be more balanced. When a polishing composition in which m1/(m1+m2) is 0.15 or more or 0.20 or more is used, more preferable results can be realized. m1/(m1+m2) is typically less than 1, and may be less than 0.95 or less than 0.90.

When the polishing composition disclosed here contains a combination of the compound $C_{pho}$ belonging to the above (C) and an acid (preferably a strong acid), the content m1C [mol/kg] of the compound $C_{pho}$ in the above (C) can be set so that m1C/(m1C+m2) is, for example, 0.30 or more. In order to improve surface quality after polishing, m1C/(m1C+m2) is preferably 0.40 or more, more preferably 0.55 or more, and may be 0.70 or more. m1C/(m1C+m2) is typically less than 1, and in order to improve polishing removal rate, it may be less than 0.95 or less than 0.90.

When the polishing composition disclosed here contains a combination of the compound $C_{pho}$ belonging to the above (A) and an acid (preferably a strong acid), regarding the content m1A [mol/kg] of the compound $C_{pho}$ in the above (A), m1A/(m1A+m2) can be set to, for example, 0.15 or more. In order to improve surface quality after polishing, m1A/(m1A+m2) is preferably 0.20 or more. m1A/(m1A+m2) is typically less than 1, and in order to improve polishing efficiency, it may be less than 0.90 or less than 0.80, or may be less than 0.70 or less than 0.60. In some embodiments, m1A/(m1A+m2) may be less than 0.50, less than 0.40 or less than 0.30.

The relationship between the content m1A of the compound $C_{pho}$ in the above (A) and the content m2 of the acid can also be preferably applied to the relationship between the content m1B of the compound $C_{pho}$ in the above (B) and the content m2 of the acid when the polishing composition disclosed here contains a combination of the compound $C_{pho}$ belonging to the above (B) and an acid (preferably a strong acid), or the relationship between the content m1D of the compound $C_{pho}$ in the above (D) and the content m2 of an acid when the polishing composition disclosed here contains a combination of the compound $C_{pho}$ belonging to the above (D) and an acid (preferably a strong acid).

(Other components)

The polishing composition disclosed here may further contain, as necessary, known additives that can be used in a polishing composition (typically, polishing composition used for polishing a material with a high hardness, for example, polishing composition used for polishing a gallium nitride substrate) such as a chelating agent, a thickener, a dispersant, a surface protective agent, a wetting agent, an organic or inorganic base, a surfactant, a corrosion inhibitor, an antiseptic agent, and an antifungal agent as long as the effects of the present invention are not impaired.

<Production of polishing composition>

A method for producing a polishing composition disclosed here is not particularly limited. For example, components contained in the polishing composition may be mixed together using a well-known mixing device such as a blade type stirrer, an ultrasonic disperser, and a homomixer. An embodiment in which these components are mixed together is not particularly limited, for example, all components may be mixed at once or mixed in an appropriately set order.

The polishing composition disclosed here may be of one-agent type or a multi-agent type including a two-agent type. For example, a solution A containing some of components among components (typically, components other than the solvent) constituting the polishing composition and a solution B containing the remaining components may be mixed and used for polishing an object to be polished.

The polishing composition disclosed here may be in a concentrated form (that is, a form of a concentrate of the polishing slurry) before it is supplied to an object to be polished. The polishing composition in such a concentrated form is advantageous in consideration of convenience, cost reduction, and the like during production, distribution, storage, and the like. The concentration factor can be, for example, about 1.2 times to 5 times in terms of volume.

The polishing composition in such a concentrated form can be used in an embodiment in which a polishing slurry is prepared by dilution at a desired timing and the polishing slurry is supplied to an object to be polished. The dilution can be typically performed by adding the above solvent to the concentrate and performing mixing. In addition, when the solvent is a mixed solvent, only some components among components constituting the solvent may be added and diluted, or a mixed solvent containing such constituent components in an amount ratio different from that of the above solvent may be added and diluted. In a multi-agent type polishing composition, some agents among these may be diluted and other agents may be then mixed to prepare a polishing slurry or a plurality of agents may be mixed and the resulting mixture may be then diluted to prepare a polishing slurry.

<Polishing method>

The polishing composition disclosed here is used for polishing an object to be polished, for example, in an embodiment including the following operations. The object to be polished is a gallium compound -based semiconductor substrate.

That is, a polishing slurry containing any of the polishing compositions disclosed here is prepared. Preparation of the polishing slurry may include dilution of the polishing composition. Alternatively, the polishing composition may be directly used as a polishing slurry. In addition, in the case of a multi-agent type polishing composition, preparation of the polishing slurry may include mixing such agents, diluting one or a plurality of agents before the mixing, diluting the resulting mixture after the mixing, and the like.

Next, the polishing slurry is supplied to the surface of the object to be polished and polishing is performed by a general method. For example, an object to be polished is set in a general polishing machine, and the polishing slurry is supplied to the surface (polishing target surface) of the object to be polished through a polishing pad of the polishing machine. Typically, while the polishing slurry is continuously supplied, the polishing pad is pressed against the surface of the object to be polished, and they are moved relative to each other (for example, rotated and moved). Polishing of the object to be polished is completed through such a polishing step.

In this specification, a polishing method of polishing a material to be polished and a method for producing a polished object by using the polishing method are provided. The polishing method includes a step of polishing an object to be polished using the polishing composition disclosed here. A polishing method according to a preferred embodiment includes a step of performing preliminary polishing (preliminary polishing step) and a step of performing final polishing (final polishing step). The preliminary polishing step herein is a step of performing preliminary polishing on an object to be polished. In a typical embodiment, the preliminary polishing step is a polishing step provided immediately before the final polishing step. In addition, the final polishing step herein is a step of performing final polishing on the object to be polished on which preliminary polishing has been performed and is a polishing step provided at the end (that is, on the most downstream side) among polishing steps performed using a polishing composition containing an abrasive. In such a polishing method including a preliminary polishing step and a final polishing step, the polishing composition disclosed here may be used in the preliminary polishing step or may be used in the final polishing step, or in both the preliminary polishing step and the final polishing step.

In a preferred embodiment, a polishing step using the polishing composition is a final polishing step. The polishing composition disclosed here can be particularly preferably used as a polishing composition (final polishing composition) used in the final polishing step performed on a surface of a material to be polished so that a high-quality surface having a low surface roughness Ra after polishing and with reduced occurrence of pits can be realized.

(Preliminary polishing composition)

When the polishing composition disclosed here is used in the final polishing step, the preliminary polishing step performed before the final polishing step is typically performed using a preliminary polishing step composition containing an abrasive and water. Hereinafter, the abrasive contained in the preliminary polishing step composition may be referred to a preliminary polishing abrasive.

The material and property of the preliminary polishing abrasive are not particularly limited. Examples of materials that can be used as the preliminary polishing abrasive include abrasives substantially composed of any of oxides such as silica particles, alumina, cerium oxide, chromium oxide, titanium dioxide, zirconium oxide, magnesium oxide, manganese dioxide, zinc oxide, and iron oxide; nitrides such as silicon nitride and boron nitride; carbides such as silicon carbide and boron carbide; diamond; carbonates such as calcium carbonate and barium carbonate; and the like. A silica abrasive or alumina abrasive is particularly preferable. Typically, an $\alpha$-alumina is used as the alumina abrasive.

Here, in this specification, regarding the composition of the abrasive, when it is described as "substantially consisting of X" or "substantially composed of X," this means that the proportion of X (purity of X) in the abrasive is 90% or more (preferably 95% or more, more preferably 97% or more, and still more preferably 98% or more, for example, 99% or more) based on the weight.

The average secondary particle diameter of the preliminary polishing abrasive is generally suitably 20 nm or more, and in consideration of polishing efficiency and the like, it is preferably 35 nm or more, more preferably 50 nm or more, and may be 60 nm or more. In addition, in order to easily improve surface quality in the final polishing step, the average secondary particle diameter of the preliminary polishing abrasive is generally suitably 2,000 nm or less, and may be 1,000 nm or less, 800 nm or less or 600 nm or less, and may be 300 nm or less, 200 nm or less, 150 nm or less, 100 nm or less or 80 nm or less. According to such a preliminary polishing composition containing the preliminary polishing abrasive (for example, silica abrasive), a high-quality surface can be achieved in the final polishing step for a shorter time.

The preliminary polishing abrasive contained in the preliminary polishing composition may be of one type or may be of two or more types having different materials, particle shapes or particle sizes. In consideration of dispersion stability for preliminary polishing and quality stability of a preliminary polishing composition, in some embodiments, for example, 70% by weight or more, preferably 80% by weight or more, more preferably 90% by weight or more, still more preferably 95% by weight or more, particularly preferably 99% by weight or more of preliminary polishing abrasives can be one type of silica abrasive or alumina abrasive. A preliminary polishing composition in which a preliminary polishing abrasive is composed of one type of silica abrasive or one type of alumina abrasive may be used. According to a preliminary polishing composition in which a preliminary polishing abrasive is composed of one type of silica abrasive (for example, colloidal silica), roughening of the surface in the preliminary polishing step can be reduced and a high-quality surface can be more efficiently realized in the final polishing step.

The concentration of the preliminary polishing abrasive is not particularly limited, but can be, for example, 0.1% by weight or more, 0.5% by weight or more, or 1% by weight or more. In addition, the concentration of the preliminary polishing abrasive can be 50% by weight or less, 40% by weight or less, 35% by weight or less or 30% by weight or less. In some embodiments, the concentration of the preliminary polishing abrasive may be, for example, 5% by weight or more, 12% by weight or more, 17% by weight or more, or 22% by weight or more. When the concentration of the preliminary polishing abrasive increases, the polishing removal rate tends to improve. The concentration can be preferably applied, for example, in an embodiment in which the preliminary polishing abrasive is composed of a silica abrasive, or 70% by weight or more of the preliminary polishing abrasive is composed of the silica abrasive.

The preliminary polishing composition may contain, as optional components, one or two or more of any of the above acids. When an acid is used, it is possible to adjust the pH of the preliminary polishing composition. For example, when the pH of the preliminary polishing composition is adjusted to less than 2.0, less than 1.5 or less than 1.0 using an acid, high polishing efficiency can be easily obtained. As the acid, a strong acid is preferable, specifically, an acid having a pKa of less than 1 is preferable, an acid having a pKa of less than 0.5 is more preferable, and an acid having a pKa of less than 0 is still more preferable. In addition, an oxo acid is preferable as the strong acid. Preferred examples of a strong acid that can be used in the preliminary polishing composition include hydrochloric acid, sulfuric acid, and nitric acid. In addition, the concentration of the acid in the preliminary polishing composition can be appropriately selected from among the concentrations of the above acids.

The preliminary polishing composition can contain, as optional components, one or two or more oxidants. The oxidant is beneficial to improving polishing efficiency and reducing surface roughness in the preliminary polishing step.

Specific examples of the oxidant used in the preliminary polishing composition include hydrogen peroxide; nitrate compounds, for example, nitrates such as iron nitrate, silver nitrate, and aluminum nitrate, and nitrate complexes such as cerium ammonium nitrate; persulfate compounds, for example, persulfate metal salts such as sodium persulfate and potassium persulfate and persulfates such as ammonium persulfate; chloric acid compounds or perchlorate compounds, for example, perchlorates and chlorates such as potassium perchlorate; bromate compounds, for example, bromates such as potassium bromate; iodate compounds, for example, iodates such as ammonium iodate; periodate compounds, for example, periodates such as sodium periodate; dichloroisocyanurates such as sodium dichloroisocyanurate and potassium dichloroisocyanurate; ferrate compounds, for example, ferrates such as potassium ferrate; permanganate compounds, for example, permanganates such as sodium permanganate and potassium permanganate; chromic acid compounds, for example, chromates such as potassium chromate and potassium dichromate; vanadate compounds, for example, metavanadates such as ammonium metavanadate, sodium metavanadate, and potassium metavanadate; perruthenate compounds such as perruthenate; molybdate compounds, for example, molybdates such as ammonium molybdate and disodium molybdate; perrhenate compounds such as perrhenate; tungstic acid compounds, for example, tungstates such as disodium tungstate; and the like. These can be used solely or two or more thereof can be used in an appropriate combination.

In some embodiments, the preliminary polishing composition contains a composite metal oxide as an oxidant. Examples of the composite metal oxide include metal nitrate, ferrate compounds, permanganate compounds, chromic acid compounds, vanadate compounds, ruthenate compounds, molybdate compounds, rhenic acid compounds, and tungstic acid compounds. Permanganate compounds, vanadate compounds, ferrate compounds, or chromic acid compounds are more preferable, and permanganate compounds or vanadate compounds are still more preferable.

When a preliminary polishing composition contains the composite metal oxide as an oxidant, the preliminary polishing composition may or may not further contain an oxidant other than the composite metal oxide. The art disclosed here can be suitably realized in an embodiment in which, regarding the oxidant, a preliminary polishing composition does not substantially contain an oxidant (for example, hydrogen peroxide or persulfate) other than the composite metal oxide. Alternatively, the preliminary polishing composition may contain other oxidants, for example, hydrogen peroxide and persulfate, in addition to the composite metal oxide.

In an embodiment in which the preliminary polishing composition contains an oxidant, the concentration of the oxidant is not particularly limited. The concentration of the oxidant is generally suitably 0.01% by weight or more, and may be 0.05% by weight or more, 0.1% by weight or more, 0.5% by weight or more, or 1.0% by weight or more. In addition, the concentration of the oxidant is generally suitably 5.0% by weight or less and may be 3.0% by weight or less, 2.5% by weight or less, 1.5% by weight or less, 1.0% by weight or less, 0.5% by weight or less or 0.3% by weight or less.

The pH of the preliminary polishing composition is not particularly limited, but can be selected from, for example, the range of about 0.5 to 12. The pH of the preliminary polishing composition can be selected in consideration of the composition of other components contained in the preliminary polishing composition and the like.

In some embodiments, the preliminary polishing composition can be an acidic composition having a pH of less than 7.0. The pH of the preliminary polishing composition may be less than 5.0, less than 3.0, or less than 2.5. In particular, the pH of the preliminary polishing composition is preferably less than 2.0, less than 1.5 or less than 1.2. When a preliminary polishing composition having a lower pH is used, the polishing removal rate tends to improve. After polishing using such a strongly acidic preliminary polishing composition, when final polishing is performed using the polishing composition disclosed here, a high-quality surface can be efficiently obtained.

When the pH of the preliminary polishing composition is less than 5.0, the preliminary polishing composition may or may not contain an oxidant. For example, a preliminary polishing composition having a pH of less than 2.0 and at least containing no hydrogen peroxide can be preferably used. When the preliminary polishing composition having a pH of less than 5.0 contains an oxidant, for example, a persulfate metal salt can be used as the oxidant. The preliminary polishing composition may be a composition having a pH of less than 5.0 or a pH of less than 3.0, and containing a persulfate metal salt and containing no hydrogen peroxide.

In addition, in some embodiments, the pH of the preliminary polishing composition may be, for example, 5.0 or more, 5.5 or more, or 6.0 or more. In addition, the pH of the preliminary polishing composition may be, for example, 10 or less or 8.0 or less. Thus, a preliminary polishing composition being a type of weakly acidic to weakly alkaline has an advantage of ease of handling. The preliminary polishing composition having the type preferably contains an oxidant. After polishing is performed using the preliminary polishing composition having a composition which is weakly acidic to weakly alkaline and contains an oxidant, when final polishing is performed using the polishing composition disclosed here, a high-quality surface can be efficiently obtained.

When the pH of the preliminary polishing composition is 5.0 or more, the preliminary polishing composition may or may not contain an acid. For example, a preliminary polishing composition having a pH of 5.5 or more and at least containing no strong acid can be preferably used.

The preliminary polishing composition can contain, as an optional component, the above compound $C_{pho}$. The relative relationship between the concentration wp [% by weight] of the compound $C_{pho}$ in the preliminary polishing composition and the concentration w1 [% by weight] of the compound $C_{pho}$ in the final polishing composition is not particularly limited. For example, wp < w1 may be satisfied, wp > w1 may be satisfied, or wp and w1 may be substantially the same. When the preliminary polishing composition contains the compound $C_{pho}$ in order to efficiently obtain a high-quality surface, the concentration thereof is preferably set so that wp < w1 is satisfied. wp may be, for example, 3/4 or less, 2/3 or less, 1/2 or less, 1/5 or less, or 1/10 or less of w1. A preliminary polishing composition according to a preferred embodiment does not contain the compound $C_{pho}$. In this case, wp is zero.

Preliminary polishing and final polishing can be applied to both polishing using a single-side polishing machine and polishing using a double-side polishing machine. In the single-side polishing machine, an object to be polished is adhered to a ceramic plate with wax, the object to be polished is held using a holder called a carrier, and while a polishing composition is supplied, a polishing pad is pressed against one side of the object to be polished, they move relative to each other (for example, rotated and moved), and thus one side of the object to be polished is polished. In the double-side polishing machine, an object to be polished is held using a holder called a carrier, and while a polishing composition is supplied from the above, a polishing pad is pressed against a side opposite to the object to be polished, these are rotated in a relative direction, and thus both sides of the object to be polished are polished at the same time.

The polishing pad used in each polishing of the preliminary polishing step and the final polishing step is not particularly limited. For example, any of those having high hardness, those having low hardness, those containing an abrasive, and those containing no abrasive may be used. In at least the second polishing step, a polishing pad containing no abrasive is preferably used. For example, a polishing pad containing no abrasive is preferably used in both the first and second polishing steps.

Here, one having high hardness is a polishing pad having an Asker C hardness of higher than 80, and one having low hardness is a polishing pad having an Asker C hardness of 80 or less. A polishing pad having high hardness is, for example, a hard polyurethane foam type or non-woven fabric type polishing pad. The polishing pad having low hardness is suitably a polishing pad in which at least the side pressed against the object to be polished is made of a soft foam resin such as a soft polyurethane foam, for example, a suede type polishing pad. In the suede type polishing pad, typically, the side pressed against the object to be polished is made of a soft polyurethane foam. The Asker C hardness can be measured using an Asker rubber hardness tester C type (commercially available from Asker). Polishing using the polishing composition disclosed here can be preferably performed using, for example, a suede type polishing pad. In particular, in the final polishing step, a suede type polishing pad is preferably used.

A polished object that is polished by the method disclosed here is typically cleaned after polishing. This cleaning can be performed using a suitable cleaning solution. A cleaning solution to be used is not particularly limited, and known or conventional ones can be appropriately selected and used.

Here, the polishing method disclosed here may include any other steps in addition to the preliminary polishing step and the final polishing step. Examples of such a step include a lapping step performed before the preliminary polishing step. The lapping step is a step of polishing an object to be polished by pressing the surface of a polishing platen (for example, a cast iron platen) against the object to be polished. Therefore, in the lapping step, no polishing pad is used. The lapping step is typically performed by supplying an abrasive (typically, a diamond abrasive) between the polishing platen and the object to be polished. In addition, the polishing method disclosed here may include additional steps (a cleaning step or a polishing step) before the preliminary polishing step or between the preliminary polishing step and the final polishing step.

<Method for producing polished object>

The art disclosed here includes a method of polishing a gallium compound based semiconductor substrate and polishing the substrate. According to the production method, a polished object having a high-quality surface (for example, a gallium nitride substrate, a gallium oxide substrate, etc.) can be efficiently provided.

<Polishing method>

The polishing method disclosed here is applied to a polishing step of a gallium compound-based semiconductor substrate (hereinafter simply referred to as a "substrate"). Before the first polishing step, a general processing such as grinding or lapping that can be applied to a gallium compound-based semiconductor substrate may be performed on the substrate in a step upstream from the polishing step.

Hereinafter, regarding the slurry used in the polishing method disclosed here, a slurry S2 used in the second polishing step and a slurry S1 used in the first polishing step will be described in this order.

<Slurry S2>

The slurry S2 in the art disclosed here includes an abrasive A2, water, and a compound $C_{pho}$. The same polishing composition as ones in the above polishing composition can be preferably used as the slurry S2.

(Abrasive A2)

The slurry S2 in the art disclosed here contains a silica abrasive A2. The concentration of the abrasive A2 in the slurry S2 is not particularly limited, but can be the same concentration as the above concentration of the abrasive in the polishing composition.

(Water)

The slurry S2 contains water as an essential component. The same water contained in the above polishing composition can be preferably used as water contained in the slurry S2.

(Compound $C_{pho}$)

The slurry S2 in the art disclosed here contains a compound $C_{pho}$ having a phosphoric acid group or a phosphonic acid group as an essential component. Since the slurry S2 containing the silica abrasive A2 contains the compound $C_{pho}$, in polishing using the slurry S2, roughening of the surface of the object to be polished can be reduced, and surface quality after polishing can be improved. Thereby, a surface having a low surface roughness Ra can be effectively realized. In addition, the compound $C_{pho}$ is beneficial to reducing the occurrence of pits on the surface of the object to be polished. The compounds $C_{pho}$ can be used solely or two or more thereof can be used in combination. The same compound $C_{pho}$ contained in the above polishing composition can be preferably used as the compound $C_{pho}$ contained in the slurry S2. The concentration [% by weight] of the compound $C_{pho}$ in the slurry S2 is not particularly limited, but can be the same concentration as the above concentration of the compound $C_{pho}$ in the above polishing composition.

(Oxidant)

In the slurry S2 in the art disclosed here, in order to more favorably exhibit the effect of improving surface quality using the compound $C_{pho}$, preferably no oxidant is contained or the concentration of the oxidant is a predetermined value or less. The concentration of the oxidant in the slurry S2 is preferably less than 0.1% by weight, more preferably less than 0.05% by weight, still more preferably less than 0.02% by weight, and particularly preferably less than 0.01% by weight. When the slurry S2 contains an oxidant, the oxidant can be selected from among the same oxidants used in the slurry S 1 to be described below. In an embodiment in which both slurries S 1 and S2 contain an oxidant, the oxidant contained in the slurry S 1 and the oxidant contained in the slurry S2 may be the same as or different from each other.
The art disclosed here can be preferably performed using the slurry S2 containing no oxidant. According to the slurry S2 in such a composition, an effect of improving surface quality using the compound $C_{pho}$ tends to be exhibited particularly favorably. Thereby, a surface having a low surface roughness Ra and with reduced occurrence of pits can be effectively realized. Among oxidants, in particular, a slurry S2 that does not contain hydrogen peroxide, sodium persulfate, potassium persulfate, ammonium persulfate, or sodium dichloroisocyanurate is preferably used. Here, in this specification, when it is described that the polishing composition (slurry) does not contain an oxidant, this means that an oxidant is at least not intentionally added, and a case in which a very small amount of an oxidant resulting from raw materials, a production method or the like is inevitably included is acceptable. A very small amount means that a molar concentration of the oxidant in the polishing composition is 0.0005 mol/L or less (preferably, 0.0001 mol/L or less, more preferably 0.00001 mol/L or less, and particularly preferably 0.000001 mol/L or less). The content of the oxidant is preferably zero or a detection limit or less.

(pH)

The pH of the slurry S2 can be in the same range as the pH of the above polishing composition.

(Acid)

The slurry S2 may contain, as necessary, one or two or more acids as optional components used for adjusting the pH and the like in addition to an abrasive, water, and a compound $C_{pho}$, which are essential components. Acids corresponding to the compound $C_{pho}$, that is, phosphoric acid, phosphorous acid, and phosphonic acid, are not included in examples of acids here. The same acid that can be contained in the above polishing composition can be preferably used as the acid that can be contained in the slurry S2. The concentration of the acid is not particularly limited, but can be the same concentration as the acid that can be contained in the above polishing composition.
In some embodiments, a total of the concentration w1 [% by weight] of the compound $C_{pho}$ in the slurry S2 and the concentration w2 [% by weight] of an acid (preferably a strong acid) can be in the same range as a total of the concentration w1 [% by weight] of the compound $C_{pho}$ and the concentration w2 [% by weight] of an acid (preferably a strong acid) in the above polishing composition.
When the slurry S2 contains a combination of the compound $C_{pho}$ and an acid (preferably a strong acid), the relationship between the content m1 [mol/kg] of the compound $C_{pho}$ and the content m2 [mol/kg] of the acid can be set to the same as the contents of the compound $C_{pho}$ and an acid (preferably a strong acid) in the above polishing composition. When the slurry S2 contains a combination of the compound $C_{pho}$ belonging to the above (C) and an acid (preferably a strong acid), the content m1C [mol/kg] of the compound $C_{pho}$ in the above (C) can be the same as the content m1C of the compound $C_{pho}$ in the above (C) in the above polishing composition, wherein the slurry S2 has a pH of less than 2.

When the slurry S2 contains a combination of the compound $C_{pho}$ belonging to the above (A) and an acid (preferably a strong acid), the content m1A [mol/kg] of the compound $C_{pho}$ in the above (A) can be the same as the content m1A of the compound $C_{pho}$ in the above (A) in the above polishing composition. The relationship between the content m1A of the compound $C_{pho}$ in the above (A) and the content m2 of the acid can also be preferably applied to the relationship between the content m1B of the compound $C_{pho}$ in the above (B) and the content m2 of the acid when the slurry S2 contains a combination of the compound $C_{pho}$ belonging to the above (B) and an acid (preferably a strong acid), or the relationship between the content m1D of the compound $C_{pho}$ in the above (D) and the content m2 of the acid when the slurry S2 contains a combination of the compound $C_{pho}$ belonging to the above (D) and an acid (preferably a strong acid).

(Other components)

The slurry S2 may further contain, as necessary, known additives that can be used in a polishing composition for polishing a gallium nitride substrate, such as a chelating agent, a thickener, a dispersant, a surface protective agent, a wetting agent, an organic or inorganic base, a surfactant, a corrosion inhibitor, an antiseptic agent, and an antifungal agent as long as the effects of the present invention are not impaired.

(Method for producing slurry S2)

A method for producing the slurry S2 is not particularly limited. For example, components contained in the slurry S2 may be mixed together using a well-known mixing device such as a blade type stirrer, an ultrasonic disperser, and a homomixer. An embodiment in which these components are mixed together is not particularly limited, for example, all components may be mixed at once or mixed in an appropriately set order. The same applies to the slurry S1.

The slurry S2 may be in a concentrated form (that is, a form of a concentrate of the polishing slurry) before it is supplied to an object to be polished. The polishing composition in such a concentrated form is advantageous in consideration of convenience, cost reduction, and the like during production, distribution, storage, and the like of the polishing composition. The concentration factor can be, for example, about 1.2 times to 5 times in terms of volume. The polishing composition in a concentrated form can be used in an embodiment in which a polishing slurry is prepared by dilution at a desired timing and the polishing slurry is supplied to an object to be polished. The dilution can be typically performed by adding the above solvent to the concentrate and performing mixing. In addition, when the solvent is a mixed solvent, only some components among components constituting the solvent may be added and diluted, or a mixed solvent containing such constituent components in an amount ratio different from that of the above solvent may be added and diluted. In a multi-agent type polishing composition, some agents among these may be diluted and other agents may be then mixed to prepare a polishing slurry or a plurality of agents may be mixed and the resulting mixture may be then diluted to prepare a polishing slurry. The same applies to the slurry S1.

<Slurry S1>

The slurry S1 used in the first polishing step contains an abrasive A1 and water. The same polishing composition as ones in the above preliminary polishing composition can be preferably used as the slurry S1. The same water as in the slurry S2 can be preferably used as water.

(Abrasive A1)

The material and property of the abrasive A1 are not particularly limited. Examples of materials that can be used as the abrasive A1 include abrasives substantially composed of any of oxides such as silica particles, alumina, cerium oxide, chromium oxide, titanium dioxide, zirconium oxide, magnesium oxide, manganese dioxide, zinc oxide, and iron oxide; nitrides such as silicon nitride and boron nitride; carbides such as silicon carbide and boron carbide; diamond; carbonates such as calcium carbonate and barium carbonate; and the like. Among these, an abrasive substantially composed of oxides such as silica, alumina, cerium oxide, chromium oxide, zirconium oxide, manganese dioxide, and iron oxide is preferable because a favorable surface can be formed. In order to easily achieve both high polishing removal rate and high surface quality after the second polishing step, a silica abrasive, alumina abrasive, or zirconium oxide abrasive is more preferable, and a silica abrasive or alumina abrasive is particularly preferable.

The silica abrasive used as the abrasive A1 can be appropriately selected from among the materials exemplified above as the silica abrasive that can be used for the slurry S2. The silica abrasive used as the abrasive A1 and the silica abrasive used as the abrasive A2 may have the same particle size and shape, or one or both of the particle size and the shape may be different from each other.

The alumina abrasive used as the abrasive A1 can be appropriately selected from among various known alumina particles and used. Examples of such known alumina particles include $\alpha$-alumina and an intermediate alumina. Here, the intermediate alumina is a general term for alumina particles other than $\alpha$-alumina, and specific examples thereof include $\gamma$-alumina, $\delta$-alumina, $\theta$-alumina, $\eta$-alumina, $\kappa$-alumina, and $\chi$-alumina. In addition, an alumina called fumed alumina based on classification by a production method (typically alumina fine particles produced when an alumina salt is in a flame at a high temperature) may be used. In addition, an alumina called colloidal alumina or alumina sol (for example, alumina hydrate such as boehmite) is also included in examples of the known alumina particles. In consideration of polishing removal rate, $\alpha$-alumina is particularly preferable.

The average secondary particle diameter of the abrasive A1 contained in the slurry S 1 is generally 20 nm or more, and in consideration of polishing removal rate and the like, it is preferably is 35 nm or more, more preferably 50 nm or more, and may be 60 nm or more. In addition, in order to easily improve surface quality in the second polishing step, the average secondary particle diameter of the abrasive A1 is generally suitably 2,000 nm or less, preferably 1,000 nm or less, and may be 800 nm or less or 600 nm or less.

In some embodiments, the average secondary particle diameter of the abrasive A1 is preferably 100 nm or more, more preferably 200 nm or more, and may be 300 nm or more or 400 nm or more. According to the abrasive A1 (for example, an alumina abrasive) having such an average secondary particle diameter, it is easy to obtain high polishing removal rate in the first polishing step.

In addition, in some embodiments, the average secondary particle diameter of the abrasive A1 is preferably 300 nm or less, more preferably 200 nm or less, and may be 150 nm or less, 100 nm or less or 80 nm or less. According to the abrasive A1 having such an average secondary particle diameter (for example, silica abrasive), a high-quality surface can also be realized in the second polishing step for a shorter time.

The same abrasive as in the above preliminary polishing composition can be preferably used as the abrasive A1 contained in the slurry S1. The concentration of the abrasive A1 in the slurry S1 is not particularly limited, but can be the same as the above concentration of the abrasive in the preliminary polishing composition.

In some other embodiments, in consideration of economic efficiency and the like, the concentration of the abrasive A1 in the slurry S1 may be, for example, 20% by weight or less, 15% by weight or less, 10% by weight or less or 5% by weight or less. The concentration can be preferably applied, for example, in an embodiment in which the abrasive A1 is composed of an abrasive having a higher hardness than a silica abrasive or in an embodiment in which 70% by weight or more of the abrasive A1 is composed of the above high-hardness abrasive. Examples of the above high-hardness abrasive include an alumina abrasive and a zirconium oxide abrasive.

(Acid)

The slurry S1 can contain, as optional components, one, two or more acids. When an acid is used, it is possible to adjust the pH of the slurry S1. For example, when the pH of the slurry S1 is adjusted to less than 2.0, less than 1.5 or less than 1.0 using an acid, high polishing removal rate can be easily obtained.

The acid used in the slurry S1 can be appropriately selected from among the above materials exemplified as an acid that can be used in the above polishing composition (or the slurry S2). The concentration of the acid can be appropriately selected from the same range of the concentration of the acid in the above polishing composition (or the slurry S2).

(Oxidant)

The slurry S1 can contain, as optional components, one or two or more oxidants. When the slurry S1 contains an oxidant, the slurry S1 can be effectively act on the surface of the object to be polished. Thereby, when the oxidant is contained in the slurry S1, this is beneficial to improving polishing removal rate and reducing surface roughness.

Specific examples of the oxidant used in the slurry S1 include hydrogen peroxide; nitrate compounds, for example, nitrates such as iron nitrate, silver nitrate, and aluminum nitrate, and nitrate complexes such as cerium ammonium nitrate; persulfate compounds, for example, persulfate metal salts such as sodium persulfate and potassium persulfate and persulfates such as ammonium persulfate; chloric acid compounds or perchlorate compounds, for example, perchlorates and chlorates such as potassium perchlorate; bromate compounds, for example, bromates such as potassium bromate; iodate compounds, for example, iodates such as ammonium iodate; periodate compounds, for example, periodates such as sodium periodate; dichloroisocyanurates such as sodium dichloroisocyanurate and potassium dichloroisocyanurate; ferrate compounds, for example, ferrates such as potassium ferrate; permanganate compounds, for example, permanganates such as sodium permanganate and potassium permanganate; chromic acid compounds, for example, chromates such as potassium chromate and potassium dichromate; vanadate compounds, for example, metavanadates such as ammonium metavanadate, sodium metavanadate, and potassium metavanadate; perruthenate compounds such as perruthenate; molybdate compounds, for example, molybdates such as ammonium molybdate and disodium molybdate; perrhenate compounds such as perrhenate; tungstic acid compounds, for example, tungstates such as disodium tungstate; and the like. These can be used solely or two or more thereof can be used in an appropriate combination.

In some embodiments of the art disclosed here, the slurry S1 contains a composite metal oxide as an oxidant. Examples of the composite metal oxide include metal nitrate, ferrate compounds, permanganate compounds, chromic acid compounds, vanadate compounds, ruthenate compounds, molybdate compounds, rhenic acid compounds, and tungstic acid compounds. Permanganate compounds, vanadate compounds, ferrate compounds, or chromic acid compounds are more preferable, and permanganate compounds or vanadate compounds are still more preferable.

In some preferred embodiments, in the slurry S1, a composite metal oxide including monovalent or divalent metal elements (excluding transition metal elements) and transition metal elements in the fourth period in the periodic table are used as the composite metal oxide. Preferred examples of the monovalent or divalent metal elements include Na, K, Mg, and Ca. Among these, Na or K is more preferable. Preferred examples of transition metal elements in the fourth period in the periodic table include Fe, Mn, Cr, V, and Ti. Among these, Mn, V, Fe, or Cr is more preferable, and Mn or V is still more preferable.

When the slurry S1 contains the composite metal oxide as an oxidant, the slurry S1 may or may not further contain an oxidant other than the composite metal oxide. The art disclosed here can be suitably realized in an embodiment in which, the slurry S1 does not substantially contain an oxidant (for example, hydrogen peroxide or persulfate) other than the composite metal oxide. Alternatively, the slurry S1 may contain other oxidants, for example, hydrogen peroxide and persulfate, in addition to the composite metal oxide.

In an embodiment in which the slurry S1 contains an oxidant, the concentration of the oxidant is not particularly limited. The concentration of the oxidant is generally suitably 0.01% by weight or more and preferably 0.05% by weight or more. In some embodiments, the concentration of the oxidant of the slurry S1 may be, for example, 0.1% by weight or more, 0.5% by weight or more, or 1.0% by weight or more. In addition, the concentration of the oxidant is generally suitably 5.0% by weight or less and preferably 3.0% by weight or less. In some embodiments, the concentration of the oxidant of the slurry S1 may be, for example, 2.5% by weight or less, 1.5% by weight or less, 1.0% by weight or less, 0.5% by weight or less or 0.3% by weight or less.

(pH)

The pH of the slurry S1 is not particularly limited, but can be selected from, for example, the range of about 0.5 to 12. The pH of the slurry S1 can be selected in consideration of the composition of other components contained in the slurry S1 and the like.

In some embodiments, the slurry S1 can be an acidic slurry having a pH of less than 7.0. The pH of the slurry S1 may be less than 5.0, less than 3.0, or less than 2.5. In particular, the pH of the slurry S1 is preferably less than 2.0, less than 1.5 or less than 1.2. When a slurry S1 having a lower pH is used, the polishing removal rate tends to improve. In the polishing method disclosed here, since polishing is additionally performed using the slurry S2 after polishing is performed using the slurry S1, even if a strongly acidic slurry S1 is used, it is possible to effectively improve surface quality in the second polishing step. Therefore, when the first polishing step in which polishing is performed using the strongly acidic slurry S1 and the second polishing step in which polishing is performed using the slurry S2 are performed in this order, a high-quality surface can be efficiently obtained.

In an embodiment in which the pH of the slurry S1 is less than 5.0, the slurry S1 may or may not contain an oxidant. For example, a slurry S1 having a pH of less than 2.0 and at least containing no hydrogen peroxide is preferably used. When a slurry S1 having a pH of less than 5.0 contains an oxidant, for example, a persulfate metal salt can be used as the oxidant. The slurry S1 may be a composition having a pH of less than 5.0 or a pH of less than 3.0, and containing a persulfate metal salt and containing no hydrogen peroxide.

In addition, in some embodiments, the pH of the slurry S1 may be, for example, 5.0 or more, 5.5 or more, or 6.0 or more. In addition, the pH of the slurry S1 may be, for example, 10 or less or 8.0 or less. Thus, the slurry S1 having a weakly acidic to weakly alkaline liquidity has an advantage of ease of handling. Preferably, S1 having the above liquidity contains an oxidant. When the first polishing step is performed using the slurry S1 having a composition which is weakly acidic to weakly alkaline and contains an oxidant, a surface suitable for improving surface quality in the second polishing step can be efficiently realized.

In an embodiment in which the pH of the slurry S1 is 5.0 or more, the slurry S1 may or may not contain an acid. For example, a slurry S1 having a pH of 5.5 or more and at least containing no strong acid can be preferably used.

(Compound $C_{pho}$)

The slurry S1 can contain, as an optional component, a compound $C_{pho}$ having a phosphoric acid group or a phosphonic acid group. When the slurry S1 contains the compound $C_{pho}$, an effect of reducing roughening of the surface in the first polishing step can be exhibited. When the slurry S1 contains the compound $C_{pho}$, the compound $C_{pho}$ can be

selected from the same compounds $C_{pho}$ that can be used in the slurry S2. In an embodiment in which both of the slurries S1 and S2 contain the compound $C_{pho}$, the compound $C_{pho}$ contained in the slurry S1 and the compound $C_{pho}$ contained in the slurry S2 may be the same as or different from each other.

When the slurry S1 contains the compound $C_{pho}$, the concentration [% by weight] of the compound $C_{pho}$ in the slurry S1 is lower than the concentration w1 [% by weight] of the compound $C_{pho}$ in the slurry S2. Hereinafter, the concentration [% by weight] of the compound $C_{pho}$ in the slurry S1 may be represented as wp. When wp is w1 or more, the efficiency of the entire multi-step polishing process including the first and second polishing step is likely to decrease, and a total polishing time required for obtaining a high-quality surface tends to be longer. In this regard, when the slurry S1 contains the compound $C_{pho}$, the concentration wp [% by weight] of the compound $C_{pho}$ is suitably 3/4 or less, and may be 2/3 or less, 1/2 or less, 1/5 or less, or 1/10 or less of the concentration w1 [% by weight] of the compound $C_{pho}$ in the slurry S2.

Here, the total polishing time is a total of the polishing time in the first polishing step and the polishing time in the second polishing step. Thereby, for example, a time from when polishing in the first polishing step is completed until polishing in the second polishing step starts is not included in the total polishing time.

The concentration wp [% by weight] of the compound $C_{pho}$ in the slurry S1 may be, for example, 0.01% by weight or more, 0.1% by weight or more, 0.5% by weight or more, or 1% by weight or more. In addition, wp is less than 5.0% by weight, less than 4.0% by weight or less than 3.0% by weight, and is preferably set so that it becomes lower than w1. The art disclosed here can be preferably realized in an embodiment in which the slurry S1 contains no compound $C_{pho}$.

(Other components)

The slurry S1 may further contain, as necessary, known additives that can be used in a polishing composition (typically, polishing composition used for polishing a material with a high hardness, for example, polishing composition used for polishing a gallium nitride substrate) such as a chelating agent, a thickener, a dispersant, a surface protective agent, a wetting agent, an organic or inorganic base, a surfactant, a corrosion inhibitor, an antiseptic agent, and an antifungal agent as long as the effects of the present invention are not impaired.

<Polishing composition set>

For example, the art disclosed here provides the following polishing composition set. That is, according to the art disclosed here, there is provided a polishing composition set including a composition Q1 and a composition Q2 which are stored separately from each other. The composition Q1 may be the slurry S1 used in the first polishing step in the polishing method disclosed here or its concentrate. The composition Q2 may be the slurry S2 used in the second polishing step in the polishing method disclosed here or its concentrate. According to the polishing composition set having such a configuration, in the multi-step polishing process including the first and second polishing steps, it is possible to suitably obtain both high polishing efficiency and a high-quality surface after polishing.

<Polishing method>

The polishing method disclosed here includes the first polishing step and the second polishing step in this order. The first polishing step is a step of polishing an object to be polished using a polishing slurry containing the slurry S1. The second polishing step is a step of additionally polishing the object to be polished on which the first polishing step has been performed, using a polishing slurry containing the slurry S2.

In the polishing method, a first polishing slurry containing any of the slurries S1 disclosed here, that is, a polishing slurry supplied to the object to be polished in polishing of the first polishing step, is prepared. In addition, a second polishing slurry containing any of the slurries S2 disclosed here, that is, a polishing slurry supplied to the object to be polished in polishing of the second polishing step, is prepared. Preparation of the polishing slurry may include using each slurry as a polishing slurry without change or may include preparing a polishing slurry by performing operations of adjusting the concentration (for example, diluting) and adjusting the pH of each slurry.

The first polishing step is performed using the prepared first polishing slurry. Specifically, the first polishing slurry is supplied to the surface of a gallium compound-based semiconductor substrate which is an object to be polished and polishing is performed by a general method. For example, an object to be polished is set in a general polishing machine through a lapping step, and the first polishing slurry is supplied to the surface of the object to be polished through a polishing pad of the polishing machine. Typically, while the first polishing slurry is continuously supplied, the polishing pad is pressed against the surface of the object to be polished and they are moved to each other (for example, rotated and moved).

Next, the second polishing step is performed using the prepared second polishing slurry. Specifically, the second polishing slurry is supplied to a gallium compound-based semiconductor substrate which is an object to be polished and polishing is performed by a general method. In the second polishing step, the second polishing slurry is supplied to the surface of the object to be polished through a polishing pad of the polishing machine after the first polishing step is finished. Typically, while the second polishing slurry is continuously supplied, the polishing pad is pressed against the surface of the object to be polished and they are moved to each other (for example, rotated and moved). Polishing of the gallium compound-based semiconductor substrate is completed through the above polishing step.

Here, in this specification, the first polishing step is a polishing step that is performed by supplying a polishing composition (slurry) containing an abrasive and water between the polishing pad and the object to be polished, and is a polishing step performed before the second polishing step. In a typical embodiment, the first polishing step is a polishing step provided immediately before the second polishing step. The first polishing step may be one-step polishing step or a polishing step in two or more steps.

In addition, the second polishing step in this specification is a polishing step provided at the end (that is, on the most downstream side) among polishing steps performed by supplying a polishing composition containing an abrasive and water between the polishing pad and the object to be polished. Therefore, the slurry S2 in the art disclosed here can be understood as a type of polishing composition used on the most downstream side among polishing compositions used in the polishing procedure of the gallium compound-based semiconductor substrate.

Polishing conditions in each polishing step are appropriately set based on common general technical knowledge for those skilled in the art in consideration of the object to be polished, target surface quality (for example, surface roughness), polishing removal rate, and the like. For example, in consideration of the polishing removal rate, a polishing pressure per 1 $cm^2$ of the processing area of the object to be polished is preferably 50 g or more, and more preferably 100 g or more. In addition, in order to modify the surface of the object to be polished due to excessive heat generation caused by the increased load and prevent deterioration of the abrasive, generally, the polishing pressure per 1 $cm^2$ of the processing area is suitably 1,000 g or less.

Generally, the linear velocity can be changed by the effect of the platen rotational speed, a rotational speed of a carrier, the size of the object to be polished, the number of objects to be polished, and the like. Higher polishing removal rate tends to be obtained when the linear velocity increases. In addition, in order to prevent damage to the object to be polished or excessive heat generation, the linear velocity can be limited to a predetermined value or less. The linear velocity may be set based on common general technical knowledge and is not particularly limited, but is preferably in a range of about 0.1 to 20 m/s and more preferably in a range of 0.5 to 5 m/s.

The amount of the polishing slurry supplied during polishing is not particularly limited. The supply amount is desirably set to a sufficient amount so that the polishing slurry is uniformly supplied to the entire surface of the object to be polished. A suitable supply amount may vary depending on the material of the object to be polished, the configuration of the polishing machine, other conditions, and the like. For example, per 1 $mm^2$ of the processing area of the object to be polished, a range of 0.001 to 0.1 mL/min is preferable and a range of 0.003 to 0.03 mL/min is more preferable.

A total polishing time in the polishing method disclosed here (that is, a total of the polishing time in the first polishing step and the polishing time in the second polishing step) is not particularly limited. By the polishing method disclosed here, for GaN and other gallium compound-based semiconductor substrates, for example, a high-quality surface can be realized in a total polishing time of 10 hours or shorter. In a total polishing time of 8 hours or shorter in some preferred embodiments and a total polishing time of 6 hours or shorter in more preferable embodiments, a high-quality surface can be realized for GaN and other gallium compound-based semiconductor substrates.

Each of the first and second polishing steps can be applied both polishing using a single-side polishing machine and polishing using a double-side polishing machine. In the single-side polishing machine, an object to be polished is adhered to a ceramic plate with wax, the object to be polished is held using a holder called a carrier, and while a polishing composition is supplied, a polishing pad is pressed against one side of the object to be polished, they move relative to each other (for example, rotated and moved), and thus one side of the object to be polished is polished. In the double-side polishing machine, an object to be polished is held using a holder called a carrier, and while a polishing composition is supplied from the above, a polishing pad is pressed against a side opposite to the object to be polished, these are rotated in a relative direction, and thus both sides of the object to be polished are polished at the same time.

The polishing pad used in each polishing step is not particularly limited. For example, any of those having high hardness, those having low hardness, those containing an abrasive, and those containing no abrasive may be used. Here, one having high hardness is a polishing pad having an Asker C hardness of higher than 80, and one having low hardness is a polishing pad having an Asker C hardness of 80 or less. A polishing pad having high hardness is, for example, a hard polyurethane foam type or non-woven fabric type polishing pad. The polishing pad having low hardness is suitably a polishing pad in which at least the side pressed against the object to be polished is made of a soft foam resin such as a soft polyurethane foam, for example, a suede type polishing pad. In the suede type polishing pad, typically, the side pressed against the object to be polished is made of a soft polyurethane foam. The Asker C hardness can be measured using an Asker rubber hardness tester C type (commercially available from Asker). The polishing method disclosed here can be suitably realized in an embodiment in which a polishing pad containing no abrasive is used in at least the second polishing step. For example, a polishing pad containing no abrasive is preferably used in both the first and second polishing steps.

Examples of a polishing pad that can be preferably used in the second polishing step include a polishing pad having a soft polyurethane foam surface, that is, a polishing pad configured to be used by pressing a soft polyurethane foam surface against an object to be polished. Here, the concept of the polishing pad having a soft polyurethane foam surface includes a pad of which the entire is made of a soft polyurethane foam and a polishing pad having a configuration in which a soft polyurethane foam layer is provided on a pad substrate (also referred to as a base substrate) such as a non-woven fabric and a polyethylene terephthalate (PET) film. Among these, a so-called suede type polishing pad having a soft polyurethane foam layer produced using a wet film forming method on a base substrate is preferably used. When the second polishing step is performed using a suede type polishing pad, a higher-quality (for example, a smaller surface roughness Ra) surface tends to be obtained.

Here, for example, a polishing pad having a configuration in which a non-woven fabric is impregnated with polyurethane is not included in the concept of the polishing pad having the soft polyurethane foam surface.

The suede pad can be preferably used in the first polishing step. In addition, the first polishing step can be preferably performed using a hard polyurethane foam type polishing pad or a non-woven fabric type polishing pad. By the hard polyurethane foam type or the non-woven fabric type polishing pad, higher polishing removal rate tends to be obtained in the first polishing step. Then, preferably, when the second polishing step in which polishing is performed using a suede pad is performed using the slurry S2, a high-quality surface can be efficiently realized.

The polished object polished by the method disclosed here is typically cleaned after polishing. This cleaning can be performed using a suitable cleaning solution. The cleaning solution to be used is not particularly limited, and known or conventional ones can be appropriately selected and used.

The polishing method disclosed here may include any other steps in addition to the first polishing step and the second polishing step. Examples of such a step include a lapping step that is performed before the first polishing step. The lapping step is a step of polishing an object to be polished by pressing the surface of a polishing platen (for example, a cast iron platen) against the object to be polished. Therefore, the polishing pad is not used in the lapping step. The lapping step is typically performed by supplying an abrasive (typically, diamond abrasive) between the polishing platen and the object to be polished. In addition, the polishing method disclosed here may include an additional step (cleaning step or other polishing steps) before the first polishing step or between the first polishing step and the second polishing step.

<Method for producing polished object>

The matters disclosed in this specification may include provision of a method for producing a polished object, which is a gallium nitride substrate or a gallium oxide substrate including performing the above polishing method and a polished object produced by the method. That is, in this specification, there are provided the method for producing the polished object including polishing by applying any of the polishing methods disclosed here and the polished object produced by the method. By the production method, the polished object having a high-quality surface be efficiently provided Examples

Several examples related to the present invention will be described below. Here, in the following description, "%" is based on weight unless otherwise specified.

<Test Example 1>

<Preparation of polishing composition>

Polishing compositions having formulations shown in Table 1 were prepared. Regarding the silica abrasive, a globular colloidal silica having an average secondary particle diameter (D50) of 65 nm was used. In Table 1, HEDP indicates hydroxyethylidene diphosphonic acid, EDTPO indicates ethylenediamine tetra(methylenephosphonic acid), and EAP indicates ethyl acid phosphate, and these correspond to the compound $C_{pho}$. Here, EAP used here was a mixture of monoesters and diesters of phosphoric acid, and had a weight average molecular weight of 140 based on their weight fraction. In addition, in Table 1, TTHA indicates triethylene tetramine hexaacetic acid, and DTPA indicates diethylenetriamine pentaacetic acid, which do not correspond to the compound $C_{pho}$ because they had neither a phosphoric acid group nor a phosphonic acid group. In addition to components shown in Table 1, a polishing composition of Example 1-3 contained 0.6% potassium hydroxide in order to dissolve EDTPO. Polishing compositions of Comparative Examples 1-3 and 1-4 contained 0.3% potassium hydroxide in order to dissolve TTHA and DTPA. The remainders of the polishing compositions according to the examples were made up of water. Table 1 also shows the pH of the polishing compositions of the examples.

<Polishing removal rate>

The polishing compositions according to the examples were directly used as polishing slurries, and the (0001) plane of a commercially available non-doped (n-type) free-standing type GaN wafer, that is, the C plane, was polished under the following polishing conditions. All of the GaN wafers used had a circular shape with a diameter of 2 inches.

[Polishing conditions]

Polishing machine: single-side polishing machine device, model "RDP-500" (commercially available from Fujikoshi Machinery Corporation)
Polishing pad: soft polyurethane foam suede pad (Surfin 019-3 commercially available from Fujimi Inc., Asker C hardness: 58)
Polishing pressure: 45 kPa
Polishing slurry supply rate: 20 mL/min (used in one-way)
Average linear velocity: 1.5 m/s
Polishing time: 60 minutes

The polishing removal rate was calculated according to the following calculation formulae (1) to (3) based on the weight of the wafer before and after the above polishing. The results are shown in Table 1.

$$(1)\ \Delta V = (W0 - W1)/\rho$$

$$(2)\ \Delta x = \Delta/S$$

$$(3)\ R = \Delta x/t$$

Here,

WO: weight of the wafer before polishing,
W1: weight of the wafer after polishing,
$\rho$: specific gravity (6.15 g/cm$^3$) of GaN,
$\Delta V$: amount in change of the volume of the wafer due to polishing,
S: surface area of wafer,
$\Delta x$: amount in change of the thickness of the wafer due to polishing,
t: polishing time (60 minutes),
R: polishing efficiency (polishing removal rate).

<Surface roughness Ra>

The surface roughness Ra of the surface of the wafer after the above polishing was performed using the polishing compositions according to the examples was measured under the following conditions. The results are shown in Table 1.

[Ra measurement conditions]

Evaluation device: atomic force microscope (AFM) (commercially available from Bruker) Device type: nanoscope V
Viewing angle: 10 $\mu$m square
Scanning speed: 1 Hz (20 $\mu$m/s)
Number of measurement points per scan: 256 (points)
Number of scans : 256 (scans)
Measurement positions: 5 positions (measurement was performed at one position at the center of the wafer and four positions on the circumference of the 1/2 radius of the wafer at intervals of 90°, and an average of measurement results at the five positions was recorded as Ra)

<Pit reduction performance>

Using five AFM images obtained in measurement of the above surface roughness Ra, the number of pits present in the AFM images was visually counted. In this case, a circular dent defect having a diameter of 100 nm or more and a depth of 2 nm or more with respect to the reference plane was determined as a pit. Based on the results, the pit reduction performance was evaluated according to the following five levels of 0 points to 4 points, and the results are shown in Table 1. A higher number indicates higher pit reduction performance.

4 points: no pits were observed in all of the five AFM images.
3 points: pits were observed in one image among five AFM images.
2 points: pits were observed in two images among five AFM images or three or more pits were observed in at least one AFM image.
1 point: pits were observed in three or more images among five AFM images or five or more pits in at least one AFM image.
0 points: the surface condition was rough and it was not possible to count the number of pits.

[Table 1]

Table 1

| | Abrasive | | Additive | | pH [ - ] | Polishing removal rate [ nm/hr ] | Ra [ nm ] | Pit reduction performance |
|---|---|---|---|---|---|---|---|---|
| | Type | [wt%] | Type | [wt%] | | | | |
| Example 1-1 | Silica | 25 | $K_2HPO_4$ Sulfuric acid | 0.85 0.88 | 1.18 | 160 | 0.08 | 3 |
| Example 1-2 | Silica | 25 | HEDP Sulfuric acid | 0.50 0.51 | 1.16 | 130 | 0.05 | 4 |
| Example 1-3 | Silica | 25 | EDTPO Sulfuric acid | 0.53 1.75 | 1.18 | 60 | 0.07 | 3 |
| Example 1-4 | Silica | 25 | EAP Sulfuric acid | 0.61 0.36 | 1.24 | 124 | 0.06 | 3 |
| Example 1-5 | Silica | 25 | Phosphoric acid | 14.4 | 0.81 | 140 | 0.07 | 3 |
| Example 1-6 | Silica | 25 | Phosphoric acid | 4.80 | 1.03 | 150 | 0.07 | 4 |
| Example 1-7 | Silica | 25 | Phosphoric acid | 1.60 | 1.64 | 120 | 0.08 | 3 |
| Example 1-8 | Silica | 25 | Phosphoric acid | 0.48 | 2.45 | 105 | 0.08 | 3 |
| Example 1-9 | Silica | 25 | Phosphoric acid Sulfuric acid | 2.40 0.55 | 1.21 | 165 | 0.07 | 3 |
| Example 1-10 | Silica | 25 | Phosphoric acid Sulfuric acid | 0.48 0.45 | 1.27 | 160 | 0.09 | 3 |
| Example 1-11 | Silica | 25 | Phosphoric acid | 0.48 | 1.21 | 165 | 0.09 | 3 |

(continued)

|  | Abrasive | | Additive | | pH [ - ] | Polishing removal rate [ nm/hr ] | Ra [ nm ] | Pit reduction performance |
|---|---|---|---|---|---|---|---|---|
|  | Type | [wt%] | Type | [wt%] | | | | |
|  |  |  | Nitric acid | 0.39 |  |  |  |  |
| Comparative Example 1-1 | Silica | 25 | Sulfuric acid | 0.84 | 1.05 | 205 | 4.41 | 0 |
| Comparative Example 1-2 | Silica | 25 | Nitric acid | 0.71 | 1.08 | 180 | 2.32 | 0 |
| Comparative Example 1-3 | Silica | 25 | TTHA Sulfuric acid | 0.40 0.93 | 1.20 | 100 | 2.48 | 0 |
| Comparative Example 1-4 | Silica | 25 | DTPA Sulfuric acid | 0.38 1.13 | 1.18 | 100 | 2.48 | 0 |

As shown in Table 1, when polishing compositions of Examples 1-1 to 1-11 containing the compound $C_{pho}$ were used, the practical polishing removal rate was maintained and the surface quality after polishing was significantly improved compared to polishing compositions of Comparative Examples 1-1 to 1-4 containing no compound $C_{pho}$.

The following experiments were additionally performed in order to know the effect resulting from inclusion of the oxidant.

That is, sodium persulfate or $H_2O_2$ as an oxidant with a concentration shown in Table 2 was additionally added to the polishing composition of Example 1-6 containing no oxidant to prepare polishing compositions according to Comparative Examples 1-5 and 1-6. In addition, $H_2O_2$ as an oxidant with a concentration shown in Table 2 was additionally added to the polishing composition of Example 1-11 containing no oxidant to prepare a polishing composition according to Comparative Example 1-7. The GaN wafer was polished in the same manner as above using the polishing compositions of these comparative examples, and pit reduction performance was evaluated. The results are shown in Table 2.

[Table 2]

Table 2

|  | Pit reduction performance | Note |
|---|---|---|
| Example 1-6 | 4 | No oxidant |
| Comparative Example 1-5 | 1 | Add sodium persulfate (1.74 wt%) to Example 1-6 |
| Comparative Example 1-6 | 1 | Add $H_2O_2$ (1.94 wt%) to Example 1-6 |
| Example 1-11 | 3 | No oxidant |
| Comparative Example 1-7 | 2 | Add $H_2O_2$ (1.94 wt%) to Example 1-11 |

As shown in Table 2, it was confirmed that the pit reduction performance was greatly impaired when the polishing compositions of Comparative Examples 1-5 and 1-6 obtained by adding an oxidant to the polishing composition of Example 1-6 were used. A similar tendency was observed in comparison between Example 1-11 and Comparative Example 1-7.

<Test Example 2>

<Preparation of polishing composition>

Slurries S1 and S2 containing abrasives and additives with concentrations shown in examples in Tables 3 and 4 were prepared. In the columns of abrasive types in Tables 3 and 4, "S" indicates a silica abrasive, and "A" indicates an alumina abrasive. A globular colloidal silica having an average secondary particle diameter (D50) of 65 nm was used as the silica abrasive. An $\alpha$-alumina having an average secondary particle diameter (D50) of 450 nm was used as the alumina abrasive. In addition, in Table 3, in the columns of additives of the slurry S2, HEDP indicates hydroxyethylidene diphosphonic acid, and EDTPO indicates ethylenediamine tetra(methylenephosphonic acid), both of which correspond to the compound $C_{pho}$. The slurry S2 of Example 2-10 contained 0.6% of potassium hydroxide in order to dissolve EDTPO in addition to components shown in Table 3. The remainders of the slurries S1 and S2 according to the examples were made up of water. Tables 3 and 4 also show the pH of the slurries S1 and S2 according to the examples.

<Polishing of GaN substrate>

(First polishing step)

The slurry S1 prepared above was directly used as a polishing slurry, and the (0001) plane of a commercially available non-doped (n-type) free-standing type GaN wafer, that is, the C plane, was polished under the following polishing conditions. All of the GaN wafers used had a circular shape with a diameter of 2 inches.

[Polishing conditions]

Polishing machine: single-side polishing machine, model "EJ-380IN" (commercially available from Engis Japan Corporation)
Polishing pad: as shown in Table 3
Polishing pressure: 30 kPa
Polishing slurry supply rate: 20 mL/min (used in one-way)
Average linear velocity: 1.0 m/s
Polishing time: as shown in Table 3

(Second polishing step)

Next, the second polishing step was performed on the surface of the GaN wafer after the first polishing step was performed using the prepared slurry S2 as a polishing slurry without change. The second polishing step was performed under the same polishing conditions as in the first polishing step except that the polishing pad and the polishing time were as shown in Table 4. However, the second polishing step was not performed in Comparative Examples 2-1 to 2-4.
Here, in the columns of polishing pads in Tables 3 and 4, "P1" indicates a soft polyurethane foam suede pad (Surfin 019-3 commercially available from Fujimi Inc., Asker C hardness: 58), "P2" indicates a hard polyurethane foam type polishing pad (Asker C hardness: 97), and "P3" indicates a non-woven fabric type polishing pad (Asker C hardness: 82).

<Surface roughness Ra>

The surface roughness Ra of the surface of the wafer after polishing was measured under the following conditions. The results are shown in Tables 3 and 4.

[Ra measurement conditions]

Evaluation device: atomic force microscope (AFM) (commercially available from Bruker) Device type: nanoscope V
Viewing angle: 10 $\mu$m square
Number of measurement points per scan: 256 (points)
Number of scans: 256 (scans)
Measurement positions: 5 positions (measurement was performed at one position at the center of the wafer and four positions on the circumference of the 1/2 radius of the wafer at intervals of 90°, and an average of measurement results at the five positions was recorded as Ra)

[Table 3]

Table 3

| | First polishing step | | | | | | | Second polishing step | | | | | | | | | Total polishing time | Ra after polishing |
| | Slurry S1 | | | | | Polishing pad | Polishing time | Slurry S2 | | | | | | | Polishing pad | Polishing time | | |
| | Abrasive | | Additive | | pH | | | Abrasive | | Additive | | $C_{pho}$ | pH | | | | | |
| | Type | Concentration (wt%) | Type | Concentration (wt%) | | | (hr) | Type | Concentration (wt%) | Type | Concentration (wt%) | Concentration (wt%) | | | | (hr) | (hr) | (nm) |
|---|---|---|---|---|---|---|---|---|---|---|---|---|---|---|---|---|---|
| Example 2-1 | S | 25 | $H_2SO_4$ | 0.9 | 1.0 | P1 | 3 | S | 25 | $H_3PO_4$ | 5.0 | 5.0 | 1.0 | P1 | 2 | 5 | 0.16 |
| Example 2-2 | S | 25 | $H_2SO_4$ | 0.9 | 1.0 | P1 | 3 | S | 25 | $H_3PO_4$ | 0.3 | 0.3 | 2.7 | P1 | 4 | 7 | 0.17 |
| Example 2-3 | S | 25 | $H_2SO_4$ | 0.9 | 1.0 | P1 | 3 | S | 25 | $H_3PO_4$ | 0.1 | 0.1 | 3.3 | P1 | 6 | 9 | 0.24 |
| Example 2-4 | S | 25 | $H_2SO_4$ | 0.9 | 1.0 | P1 | 2 | S | 25 | $H_3PO_4$ | 12.0 | 12.0 | 0.8 | P1 | 5 | 7 | 0.17 |
| Example 2-5 | S | 25 | $H_2SO_4$ | 0.9 | 1.0 | P1 | 2 | S | 25 | $H_3PO_4$ | 20.0 | 20.0 | 0.7 | P1 | 5 | 7 | 0.21 |
| Example 2-6 | S | 25 | $HNO_3$ | 0.8 | 1.0 | P1 | 2 | S | 25 | $H_3PO_4$ | 5.0 | 5.0 | 1.0 | P1 | 5 | 7 | 0.15 |
| Example 2-7 | S | 25 | $HNO_3$ / $H_3PO_4$ | 0.7 / 2.5 | 0.9 | P1 | 4 | S | 25 | $H_3PO_4$ | 5.0 | 5.0 | 1.0 | P1 | 4 | 8 | 0.16 |
| Example 2-8 | S | 25 | $HNO_3$ / $H_3PO_4$ | 0.7 / 0.3 | 1.0 | P1 | 3 | S | 25 | $H_3PO_4$ | 5.0 | 5.0 | 1.0 | P1 | 4 | 7 | 0.16 |
| Example 2-9 | S | 25 | $H_2SO_4$ | 0.9 | 1.0 | P1 | 2 | S | 25 | HEDP / $H_2SO_4$ | 0.7 / 0.6 | 0.7 | 1.0 | P1 | 4 | 6 | 0.13 |
| Example 2-10 | S | 25 | $H_2SO_4$ | 0.9 | 1.0 | P1 | 3 | S | 25 | EDTPO / $H_2SO_4$ | 0.6 / 0.9 | 0.6 | 1.0 | P1 | 4 | 7 | 0.18 |

EP 3 780 069 B1

(continued)

| | First polishing step | | | | | | | Second polishing step | | | | | | | | Total polish-ing time | Ra after polish-ing |
|---|---|---|---|---|---|---|---|---|---|---|---|---|---|---|---|---|---|
| | Slurry S1 | | | | | Polish-ing pad | Polish-ing time | Slurry S2 | | | | | | Polish-ing pad | Polish-ing time | | |
| | Abrasive | | Additive | | pH | | | Abrasive | | Additive | | $C_{pho}$ | pH | | | | |
| | Type | Concentra-tion (wt%) | Type | Concentra-tion (wt%) | | | (hr) | Type | Concentra-tion (wt%) | Type | Concentra-tion (wt%) | Concentra-tion (wt%) | | | (hr) | (hr) | (nm) |
| Example 2-11 | S | 25 | HNO3 | 0.8 | 1.0 | P1 | 2 | S | 25 | K2HPO4 H2SO4 | 0.8 1.0 | 0.8 | 1.0 | P1 | 5 | 7 | 0.15 |
| Example 2-12 | S | 25 | H2SO4 K2S2O8 | 1.0 2.0 | 1.0 | P3 | 2 | S | 25 | H3PO4 | 5.0 | 5.0 | 1.0 | P1 | 4 | 6 | 0.17 |
| Example 2-13 | A | 3 | KMnO4 | 0.1 | 7.0 | P2 | 1 | S | 25 | H3PO4 | 5.0 | 5.0 | 1.0 | P1 | 7 | 8 | 0.15 |
| Example 2-14 | S | 25 | NaVO3 H2O2 | 1.8 1.2 | 7.0 | P1 | 3 | S | 25 | H3PO4 | 5.0 | 5.0 | 1.0 | P1 | 5 | 8 | 0.16 |
| Example 2-15 | S | 25 | NaVO3 H2O2 | 1.8 1.2 | 7.0 | P1 | 4 | S | 25 | H3PO4 | 0.1 | 0.1 | 3.3 | P1 | 6 | 10 | 0.22 |

EP 3 780 069 B1

[Table 4]

Table 4

| | First polishing step | | | | | | | | Second polishing step | | | | | | | | | | Total polish-ing time | Ra after polish-ing |
| | Slurry S1 | | | | | Polish-ing pad | Polish-ing time | | Slurry S2 | | | | | | | Polish-ing pad | Polish-ing time | | |
| | Abrasive | | Additive | | pH | | | | Abrasive | | Additive | | $C_{pho}$ | pH | | | | | |
| | Type | Concentra-tion (wt%) | Type | Concentra-tion (wt%) | | | (hr) | | Type | Concentra-tion (wt%) | Type | Concentra-tion (wt%) | Concentra-tion (wt%) | | | | (hr) | (hr) | (nm) |
| Compara-tive Exam-ple 2-1 | A | 3 | KMnO4 | 0.1 | 7.0 | P1 | 4 | | | | | | | | | | | 4 | 1.07 |
| Compara-tive Exam-ple 2-2 | S | 25 | H2SO4<br><br>K2S2O8 | 1.0<br><br>2.0 | 1.0 | P1 | 2 | | | | | | | | | | | 2 | 2.73 |
| Compara-tive Exam-ple 2-3 | S | 25 | H2SO4<br><br>K2S2O8 | 1.0<br><br>2.0 | 1.0 | P1 | 4 | | | | | | | | | | | 4 | 4.70 |
| Compara-tive Exam-ple 2-4 | S | 25 | H3PO4 | 5.0 | 1.0 | P1 | 10 | | | | | | | | | | | 10 | 0.36 |
| Compara-tive Exam-ple 2-5 | S | 25 | H3PO4 | 5.0 | 1.0 | P1 | 6 | | S | 25 | H3PO4<br><br>H2SO4 | 0.1<br><br>0.8 | 0.1 | 1.0 | P1 | 4 | 10 | 0.33 |

As shown in Tables 3 and 4, according to Examples 2-1 to 2-15, a high-quality surface having an Ra of 0.3 nm or less was efficiently obtained under a condition in which a total polishing time was within 10 hours. Among these, in Examples 2-1, 2-9, and 2-12, a high-quality surface was obtained in a shorter total polishing time. In addition, in Examples 2-1, 2-6 to 2-9, 2-11, and 2-13, the surface quality after polishing was particularly favorable. On the other hand, in Comparative Examples 2-1 to 2-3, Ra after polishing was high and even if the polishing time was extended to 10 hours, reduction of Ra was insufficient. In Comparative Examples 2-4 and 2-5, it was not possible to obtain a surface having Ra of 0.3 nm or less within 10 hours. Here, it was confirmed that, when the polishing pad used in the second polishing step in Example 2-13 was changed from P1 to P3, the surface roughness Ra after polishing was larger than that of Example 2-13.

While specific examples of the present invention have been described above in detail, the technology described may involve various modifications and alternations of the specific examples exemplified above as long as these fall within the scope of the appended claims.

**Claims**

1. A polishing composition configured to be used for polishing a gallium compound-based semiconductor substrate, comprising:

   a silica abrasive;
   a compound, $C_{pho}$, having a phosphoric acid group or a phosphonic acid group; and
   water; wherein
   the polishing composition contains no oxidant,
   wherein the pH is less than 2,
   wherein the concentration of the compound, $C_{pho}$, is within the range of 0.05% by weight or more and 25% by weight or less, and
   wherein the compound, $C_{pho}$, includes at least one of the following compounds:

      A: a chelate compound having a phosphonic acid group,
      B: a compound selected from the group consisting of phosphoric acid mono C1-4 alkyl esters, phosphoric acid di C1-4 alkyl esters and phosphorous acid mono C1-4 alkyl esters,
      C: at least one of phosphoric acid and phosphorous acid, and
      D: a compound selected from the group consisting of inorganic salts of phosphoric acid and inorganic salts of phosphorous acid.

2. The polishing composition according to claim 1, further comprising an acid.

3. The polishing composition according to claim 2, wherein
   the relationship between a content, m1, in mol/kg, of the compound, $C_{pho}$, and a content, m2, in mol/kg, of the acid satisfy the following formula:

$$m1/(m1 + m2) \geq 0.1.$$

4. The polishing composition according to any one of claims 1 to 3, wherein
   the gallium compound-based semiconductor substrate is a gallium nitride substrate or a gallium oxide substrate.

5. A polishing method comprising supplying the polishing composition according to any one of claims 1 to 4 to a gallium compound-based semiconductor substrate and polishing the substrate.

6. A method of polishing a gallium compound-based semiconductor substrate, comprising:

   a first polishing step in which polishing is performed using a slurry, S1, containing an abrasive, A1, and water; and
   a second polishing step in which polishing is performed using a slurry, S2, containing an abrasive, A2, and water, in this order, wherein
   the abrasive, A2, includes a silica abrasive,
   the slurry, S2, further contains a compound, $C_{pho}$, having a phosphoric acid group or a phosphonic acid group, and

the slurry, S1, does not contain the compound, $C_{pho}$, or a concentration, in % by weight, of the compound, $C_{pho}$, in the slurry, S1, is lower than a concentration, in % by weight, of the compound, $C_{pho}$, in the slurry, S2, and wherein the slurry, S2, has a pH of less than 2,
wherein the concentration of the compound, $C_{pho}$, in the slurry, S2, is within the range of 0.05% by weight or more and 25% by weight or less, and
wherein the compound, $C_{pho}$, includes at least one of the following components:

A: a chelate compound having a phosphonic acid group,
B: a compound selected from the group consisting of phosphoric acid mono C1-4 alkyl esters, phosphoric acid di C1-4 alkyl esters and phosphorous acid mono C1-4 alkyl esters,
C: at least one of phosphoric acid and phosphorous acid, and
D: a compound selected from the group consisting of inorganic salts of phosphoric acid and inorganic salts of phosphorous acid.

7. The polishing method according to claim 6 wherein
the slurry, S1, has a pH of less than 2.0.

8. The polishing method according to claim 6 or 7, wherein
the slurry, S1, contains a strong acid.

9. The polishing method according to any one of claims 6 to 8, wherein
the slurry, S1, contains an oxidant.

10. The polishing method according to claim 9, wherein
the oxidant contains at least one selected from the group consisting of a permanganate, metavanadate, and persulfate.

11. The polishing method according to any one of claims 6 to 10, wherein
the abrasive, A1, contains a silica abrasive.

12. The polishing method according to any one of claims 6 to 11, wherein
a concentration of the compound, $C_{pho}$, in the slurry, S2, is 0.2% by weight or more and 15% by weight or less.

13. The polishing method according to any one of claims 6 to 12, wherein,
in the second polishing step, polishing is performed using a polishing pad having a soft polyurethane foam surface.


**Patentansprüche**

1. Polierzusammensetzung, die so konfiguriert ist, dass sie zum Polieren eines Halbleitersubstrats auf Basis einer Galliumverbindung verwendet werden kann, umfassend:

ein Siliziumdioxid-Schleifmittel;
eine Verbindung, $C_{pho}$,
besitzend eine Phosphorsäuregruppe oder eine Phosphonsäuregruppe; und
Wasser; wobei
die Polierzusammensetzung kein Oxidationsmittel enthält,
wobei der pH-Wert weniger als 2 ist,
wobei die Konzentration der Verbindung, $C_{pho}$, im Bereich von 0,05 Gew.-% oder mehr und 25 Gew.-% oder weniger ist, und
wobei die Verbindung, $C_{pho}$, mindestens eine der folgenden Verbindungen beinhaltet:

A: eine Chelatverbindung, besitzend eine Phosphonsäuregruppe,
B: eine Verbindung, ausgewählt aus der Gruppe, bestehend aus Phosphorsäuremono-C1-4-alkylestern, Phosphorsäuredi-C1-4-alkylestern und Phosphorigsäuremono-C1-4-alkylestern,
C: mindestens eine von Phosphorsäure und phosphoriger Säure, und
D: eine Verbindung, ausgewählt aus der Gruppe, bestehend aus anorganischen Salzen der Phosphorsäure und anorganischen Salzen der phosphorigen Säure.

**2.** Die Polierzusammensetzung nach Anspruch 1, weiter umfassend eine Säure.

**3.** Die Polierzusammensetzung nach Anspruch 2, wobei
das Verhältnis zwischen einem Gehalt, m1, in mol/kg, der Verbindung, $C_{pho}$ , und einem Gehalt, m2, in mol/kg, der Säure die folgende Formel erfüllt:

$$m1/(m1 + m2) \geq 0,1.$$

**4.** Die Polierzusammensetzung nach irgendeinem der Ansprüche 1 bis 3, wobei
das Halbleitersubstrat auf Basis einer Galliumverbindung ein Galliumnitrid- oder ein Galliumoxidsubstrat ist.

**5.** Polierverfahren, umfassend das Aufbringen Polierzusammensetzung nach irgendeinem der Ansprüche 1 bis 4 auf ein Halbleitersubstrat auf Basis einer Galliumverbindung und Polieren des Substrats.

**6.** Verfahren zum Polieren eines Halbleitersubstrats auf Basis einer Galliumverbindung, umfassend:

einen ersten Polierschritt, bei dem das Polieren unter Verwenden einer Aufschlämmung, S1, enthaltend ein Schleifmittel, A1, und Wasser, durchgeführt wird; und
einen zweiten Polierschritt, bei dem das Polieren unter Verwenden einer Aufschlämmung, S2, enthaltend ein Schleifmittel, A2, und Wasser, durchgeführt wird, in dieser Reihenfolge, wobei
das Schleifmittel, A2, ein Siliziumdioxid-Schleifmittel beinhaltet,
die Aufschlämmung, S2, weiter eine Verbindung, $C_{pho}$ , besitzend eine Phosphorsäuregruppe oder einer Phosphonsäuregruppe, enthält, und
die Aufschlämmung, S1, die Verbindung, $C_{pho}$ , nicht enthält oder die Konzentration, in Gew-%, der Verbindung, $C_{pho}$ , in der Aufschlämmung, S1, geringer als die Konzentration, in Gew-%, der Verbindung, $C_{pho}$ , in der Aufschlämmung, S2, ist, und
wobei die Aufschlämmung, S2, einen pH-Wert von weniger als 2 besitzt,
wobei die Konzentration der Verbindung, $C_{pho}$ , in der Aufschlämmung, S2, im Bereich von 0,05 Gew.-% oder mehr und 25 Gew.-% oder weniger ist, und
wobei die Verbindung, $C_{pho}$ , mindestens eine der folgenden Komponenten beinhaltet:

A: eine Chelatverbindung, besitzend eine Phosphonsäuregruppe,
B: eine Verbindung, ausgewählt aus der Gruppe bestehend aus Phosphorsäuremono-C1-4-alkylestern, Phosphorsäuredi-C1-4-alkylestern und Phosphorigsäuremono-C1-4-alkylestern,
C: mindestens eine von Phosphorsäure und phosphoriger Säure, und
D: eine Verbindung, ausgewählt aus der Gruppe, bestehend aus anorganischen Salzen der Phosphorsäure und anorganischen Salzen der phosphorigen Säure.

**7.** Das Polierverfahren nach Anspruch 6, wobei
die Aufschlämmung, S1, einen pH-Wert von weniger als 2,0 besitzt.

**8.** Das Polierverfahren nach Anspruch 6 oder 7, wobei
die Aufschlämmung, S1, eine starke Säure enthält.

**9.** Das Polierverfahren nach irgendeinem der Ansprüche 6 bis 8, wobei
die Aufschlämmung, S1, ein Oxidationsmittel enthält.

**10.** Das Polierverfahren nach Anspruch 9, wobei
das Oxidationsmittel mindestens eines aus der Gruppe, bestehend aus Permanganat, Metavanadat und Persulfat, enthält.

**11.** Das Polierverfahren nach irgendeinem der Ansprüche 6 bis 10, wobei das Schleifmittel, A1, ein Siliziumdioxid-Schleifmittel enthält.

**12.** Das Polierverfahren nach irgendeinem der Ansprüche 6 bis 11, wobei
eine Konzentration der Verbindung, $C_{pho}$ , in der Aufschlämmung, S2, 0,2 Gew.-% oder mehr und 15 Gew.-% oder weniger ist.

**13.** Das Polierverfahren nach irgendeinem der Ansprüche 6 bis 12, wobei, im zweiten Polierschritt, das Polieren unter Verwenden eines Polierkissens, besitzend eine weiche Polyurethanschaumoberfläche, durchgeführt wird.

**Revendications**

**1.** Composition de polissage configurée pour être utilisée pour polir un substrat semi-conducteur à base d'un composé de gallium, comprenant ;

un abrasif en silice ;
un composé, $C_{pho}$,
ayant un groupe acide phosphorique ou un groupe acide phosphonique ; et
de l'eau ; où
la composition de polissage ne contient pas d'oxydant,
où le pH est inférieur à 2,
où la concentration du composé $C_{pho}$ est comprise entre 0,05 % en poids ou plus et 25 % en poids ou moins, et
où le composé, $C_{pho}$, inclut au moins l'un des composés suivants :

A : un chélate ayant un groupe acide phosphonique,
B : un composé choisi dans le groupe constitué par les mono C1-4 alkyl esters d'acide phosphorique, les di C1-4 alkyl esters d'acide phosphorique et les mono C1-4 alkyl esters d'acide phosphoreux,
C : au moins un parmi un acide phosphorique et un acide phosphoreux, et
D : un composé choisi dans le groupe constitué par les sels inorganiques de l'acide phosphorique et les sels inorganiques de l'acide phosphoreux.

**2.** Composition de polissage selon la revendication 1, comprenant en outre un acide.

**3.** Composition de polissage selon la revendication 2, où
la relation entre une teneur, m1, en mol/kg, du composé, Cpho, et une teneur, m2, en mol/kg, de l'acide satisfait à la formule suivante :

$$m1/(m1 + m2) \geq 0,1.$$

**4.** Composition de polissage selon l'une quelconque des revendications 1 à 3, où
le substrat semi-conducteur à base de composé de gallium est un substrat de nitrure de gallium ou un substrat d'oxyde de gallium.

**5.** Procédé de polissage comprenant l'apport de la composition de polissage selon l'une quelconque des revendications 1 à 4 à un substrat semi-conducteur à base de composé de gallium et à polir le substrat.

**6.** Procédé de polissage d'un substrat semi-conducteur à base de composé de gallium, comprenant :

une première étape de polissage dans laquelle le polissage est effectué à l'aide d'une solution, S1, contenant un abrasif, A1, et de l'eau ; et
une deuxième étape de polissage dans laquelle le polissage est effectué à l'aide d'une solution, S2, contenant un abrasif, A2, et de l'eau, dans cet ordre, où
l'abrasif, A2, inclut un abrasif en silice,
la solution, S2, contient en outre un composé, $C_{pho}$, ayant un groupe acide phosphorique ou un groupe acide phosphonique, et
la solution, S1, ne contient pas le composé, $C_{pho}$, ou bien une concentration, en % en poids, du composé, $C_{pho}$, dans la solution, S1, est inférieure à une concentration, en % en poids, du composé, $C_{pho}$, dans la solution, S2, et
où la solution, S2, a un pH inférieur à 2,
où la concentration du composé $C_{pho}$ dans la solution, S2, est comprise entre 0,05 % en poids ou plus et 25 % en poids ou moins, et
où le composé, $C_{pho}$, inclut au moins l'un des composés suivants :

A : un chélate ayant un groupe d'acide phosphonique,

B : un composé choisi dans le groupe constitué par les mono C1-4 alkyl esters d'acide phosphorique, les di C1-4 alkyl esters d'acide phosphorique et les mono C1-4 alkyl esters d'acide phosphoreux,

C : au moins un parmi un acide phosphorique et un acide phosphoreux, et

D : un composé choisi dans le groupe constitué par les sels inorganiques de l'acide phosphorique et les sels inorganiques de l'acide phosphoreux.

7. Procédé de polissage selon la revendication 6, où
la solution, S1, a un pH inférieur à 2,0.

8. Procédé de polissage selon la revendication 6 ou 7, où
la solution, S1, contient un acide fort.

9. Procédé de polissage selon l'une quelconque des revendications 6 à 8, où
la solution, S1, contient un oxydant.

10. Procédé de polissage selon la revendication 9, où
l'oxydant contient au moins un élément choisi dans le groupe constitué du permanganate, du métavanadate et du persulfate.

11. Procédé de polissage selon l'une quelconque des revendications 6 à 10, où
l'abrasif, A1, contient un abrasif en silice.

12. Procédé de polissage selon l'une quelconque des revendications 6 à 11, où
la concentration du composé $C_{pho}$ dans la solution S2 est de 0,2 % en poids ou plus et de 15 % en poids ou moins.

13. Procédé de polissage selon l'une quelconque des revendications 6 à 12, où,
lors de la deuxième étape de polissage, le polissage est effectué en utilisant un tampon de polissage ayant une surface en mousse de polyuréthane douce.

32

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018061192 A
- JP 2018061193 A
- JP 2015153852 A
- JP 2013201176 A
- JP 5116305 B
- US 2014024216 A1
- JP 2007109777 A